# EUROPEAN PATENT SPECIFICATION

(11) **EP 0 531 985 B1**
(45) Date of publication and mention of the grant of the patent: **24.02.1999**
(21) Application number: 92115465.4
(22) Date of filing: 10.09.1992
(51) Int. Cl.: H03H 9/02, H03H 3/08

(54) **Electro-acoustic hybrid integrated circuit and manufacturing method thereof**
Elektroakustische hybride integrierte Schaltung und ihre Herstellungsverfahren
Circuit électro-acoustique hybride intégré et sa méthode de fabrication

(30) Priority: 12.09.1991 JP 232841/91; 10.02.1992 JP 23488/92; 04.03.1992 JP 46907/92
(43) Date of publication of application: 17.03.1993
(60) Divisional application: 97117914.8
(73) Proprietor: MATSUSHITA ELECTRIC INDUSTRIAL CO., LTD., Kadoma-shi, Osaka-fu, 571 (JP)
(72) Inventor: Eda, Kazuo, Nara-shi, Nara 631 (JP); Taguchi, Yutaka, Settsu-shi, Osaka 566 (JP); Kanaboshi, Akihiro, Neyagawa-shi, Osaka 572 (JP); Ogura, Tetsuyoshi, Yodogawa-ryo, Osaka-shi, Osaka 532 (JP)
(74) Representative: Eisenführ, Speiser & Partner

(56) References cited:
- DE-A- 3 922 671
- US-A- 4 665 374
- PATENT ABSTRACTS OF JAPAN vol. 015, no. 423 (E-1127)28 October 1991 & JP-A-3 178 206 ( NEC ) 2 August 1991
- Journal of Applied Physics 15 Oct. 1986, Vol. 60, No. 8, pages 2987-2989, "Silicon to Silicon direct Bonding Method" [SHIMBO et al]

## Description

### BACKGROUND OF THE INVENTION

### Field of the Invention

The present invention relates to an electro-acoustic hybrid integrated circuit which uses the conversion of sonic energy to electric energy or vice versa, in particular to a high frequency circuit such as a voltage controlled oscillator, which incorporates a semiconductor device and an electro-acoustic element such as a surface acoustic wave resonator or a quartz oscillator, and a manufacturing method thereof.

### Description of the Prior Art

An electro-acoustic circuit such as a voltage controlled oscillator (VCO) comprises a transistor as an active element to cause the oscillation, an electro-acoustic element to resonate or oscillate at a desired frequency, and some electronics components such as capacitors and resistors. The electro-acoustic element is an element which converts a sonic energy to an electric energy or vice versa, such as a surface acoustic wave resonator of lithium niobate (LiNbO₃) or lithium tantalate (LiTaO₃) or a quartz oscillator.

An electro-acoustic circuit includes following circuits. Fig. 1 shows an example of a voltage controlled oscillator which comprises a surface wave resonator (SAW) as an electro-acoustic element, a transistor (Tr), varactor diodes (D) and passive components of capacitors, inductors and resistors. Fig. 2 shows another example of a voltage controlled oscillator wherein a crystal resonator (X) as an electro-acoustic element is used instead of the surface wave resonator. Fig. 3 shows an example of a high frequency amplifier which comprises a frequency filter (F) of quartz filter or surface acoustic wave filter, a transistor (Tr) and passive components. Fig. 4 shows an example of a temperature compensated crystal oscillator (TCXO) which comprises a quartz oscillator (X), a transistor (Tr), varactor diodes (D), a thermister (Th) and passive components. That is, these circuits include an electro-acoustic element such as a surface acoustic wave resonator, a quartz oscillator or a surface acoustic wave filter or quartz filter besides a transistor as an active component.

Previously, an electro-acoustic element is sealed in a container such as a metal case in order to keep the prescribed oscillation or resonance frequency stably for a long time, and an electro-acoustic circuit is constructed on a board by mounting various components including the electro-acoustic element. However, this makes the size of the surface acoustic wave resonator or the quartz oscillator several times the size of the relevant resonance or oscillation section itself. Then, for applications such as car telephones or portable telephones which are required to be compact, it is an important problem to make the size of an electro-acoustic circuit smaller.

In order to reduce the size of such an electronics circuit, it is desirable to integrate a semiconductor element including a transistor with an electro-acoustic element. For example, K. Tsubouchi el al. produces a surface acoustic wave (SAW) device by growing an aluminum nitride film as a piezo-electric substance on a silicon substrate (Zero Temperature-Coefficient SAW Devices on AlN Epitaxial Films, IEEE Transactions on Sonics and Ultrasonics, SU-32 (1985) 634-644). In order to realize a good oscillation or resonance characteristic, a film has to be grown epitaxially or aligned in a specified crystal axis direction. However, such an epitaxially grown or aligned film is realized only for some materials such as aluminum nitride or zinc oxide, while a material such as lithium niobate or lithium tantalate suitable for a surface acoustic wave resonator cannot be integrated.

As to a quartz oscillator, it is required to make the thickness small with polishing or etching in order to produce a high frequency oscillator in the submicrowave band from 800 MHz to 1.9 GHz used for car telephones and for portable telephones. For example, A. Lepek et al. (A New Design for High Frequency Bulk Resonators, 43rd Annual Symposium on Frequency Control (1989) pp. 544-547) reported that quartz is polished to a thickness of about 10 µm with a precise polishing technique to realize the oscillation at a few hundreds MHz. E.A. Gerber et al. (Advances in Microwave Acoustic Frequency Sources, IEEE Transactions on MTT 34 (1986) 1002-1016) also reported quartz resonators operating above 1GHz.

However, it is very difficult to manufacture the quartz oscillator or the quartz resonator of thickness less than 10 µm practically. If the thickness is decreased less than 10 µm, it is difficult to fix the quartz plate as an oscillator because the mechanical strength is very weak and the handling of the plate is difficult. Then, the productivity is poor and the cost is high. Practically, it is very difficult substantially to produce a voltage controlled oscillator at a high frequency of 500 MHz or higher with use of a fundamental oscillation mode of quartz oscillator. If a higher harmonic oscillator mode is used, the Q of the resonance decreases. Then, it is also difficult to produce an oscillator of high and stable performance.

In order to make a voltage controlled oscillator compact and to increase the oscillation frequency at the same time, Grudkowski et al. (Fundamental-mode VHF/UHF Miniature Acoustic Resonators and Filters on Silicon, Appl. Phys. Lett. 37 (1980) 993-995) prepares a ZnO film resonator above an air gap on a silicon substrate to produce a resonator in the submicrowave band. In this case, a resonator of film thickness of a few µm can be prepared easily, and it is possible to produce a resonator in the submicrowave band. However, the temperature dependence of resonance frequency and the Q of the resonance of a ZnO film are worse than a quartz oscillator. Then the performance of the resonator is inferior than that with use of a quartz oscillator.

This situation is a common problem to be solved for various high frequency apparatuses such as a voltage controlled oscillator, a temperature compensation crystal oscillator and a high frequency amplifier with use of an electro-acoustic element.

The German patent application DE - A - 39 22 671 discloses an electro-acoustic component with a surface wave arrangement and an electric semiconductor circuit. For the integration of a surface acoustic wave (SAW) element and a semiconductor circuit into one monolithic device the proposed process comprises: forming an etching stopping layer in a semiconductor wafer, forming a semiconductor layer on said etching stopping layer, etching away the back side of the semiconductor wafer and joining a SAW wafer to the etched side of the semiconductor layer. The SAW wafer is attached to the etched side of the semiconductor layer either by means of adhesive or by means of wafer bonding by use of Van-der-Waals bonding.

M. Shimbo, et. al. in Journal of applied physics, vol. 60, no. 8. pages 2987 - 2989 describes a bonding method between two silicon layers. Shimbo et. al. found that a strong bonding takes place when a pair of clean, mirror-polished silicon surfaces are contacted at room temperature after hydrochillic surface formation.

### SUMMARY OF THE INVENTION

It is an object of the present invention to provide an electro-acoustic hybrid integrated circuit suitable for various high frequency apparatus such as a voltage controlled oscillator of smaller size, of lighter weight and of better performance.

It is another object of the present invention to provide a manufacturing method of such an electro-acoustic hybrid integrated circuit.

According to the present invention an integrated unitary body for use in an electronic device, especially in an electro-acoustic hybrid integrated circuit. is provided, said integrated unitary body comprising: a semiconductor substrate; a single crystalline piezoelectric substrate; and a film including silicon between said semiconductor substrate and said single crystalline piezoelectric substrate; whereby said semiconductor substrate and said piezoelectric substrate are directly bonded via said film without any organic adhesives, wherein the bonding between said film and said semiconductor substrate is between component atoms of said film and oxygen and/or component atoms of said semiconductor substrate and wherein the bonding between said film and said piezoe!ectric substrate is between component atoms of said film and oxygen atoms of said piezoelectric substrate.

An electro-acoustic hybrid integrated circuit according to the present invention comprises a semiconductor substrate; a single crystalline piezoelectric substrate; and a film including silicon between said semiconductor substrate and said single crystalline piezoelectric substrate: whereby said semiconductor substrate and said piezoelectric substrate are directly bonded via said film without any organic adhesives, wherein the bonding between said film and said semiconductor substrate is between component atoms of said film and oxygen and/or component atoms of said semiconductor substrate and wherein the bonding between said film and said piezoelectric substrate is between component atoms of said film and oxygen atoms of said piezoelectric substrate.

In an electro-acoustic hybrid integrated circuit according to the present invention, an active element such as a transistor is formed on the surface of a semiconductor substrate, while an electro-acoustic element is formed with a monocrystalline piezoelectric substrate. The monocrystalline piezoelectric substrate are bonded directly to the semiconductor substrate via a film including silicon. The electro-acoustic element and the active element as well as passive components are connected to form an electro-acoustic circuit.

Further, a method for manufacturing an unitary body for use in an electronic device, especially for use in an electro-acoustic hybrid integrated circuit, comprises according to the present invention the steps of: providing a semiconductor substrate; providing a single crystalline piezoelectric substrate; forming a film including silicon on at least one of said semiconductor substrate and said piezoelectric substrate and bonding said semiconductor substrate with said piezoelectric substrate via said film; whereby the step of bonding said semiconductor substrate with said piezoelectric substrate comprises the steps of: cleaning the surface of said semiconductor substrate or said film formed on saic semiconductor substrate, respectively, and making it hydrophillic; cleaning the surface of said piezoelectric substrate or said film formed on said piezoelectric substrate, respectively, making it hydrophillic; laying it on the surface of said semiconductor substrate or said film formed on said semiconductor substrate, respectively; and performing heat treatment of said semiconductor substrate bonded with said piezoelectric substrate.

When the electro-acoustic hybrid integrated circuit is manufactured, pretreatment processes necessary for forming an active element are performed first, on the semiconductor substrate at processing temperatures higher than the heat treatment temperature for direct bonding. Then, a thin film including silicon is formed on at least either of the semiconductor substrate and the monocrystalline piezoelectric element, and the semiconductor substrate directly with the electro-acoustic element via the thin films. Next, posttreatment processes for forming the active element and for the metallization are performed at a processing temperature lower than the heat treatment temperature for direct bonding and processes for forming an electro-acoustic element on the monocrystalline piezoelectric element. Thus, an active element and the electro-acoustic element are integrated as a hybrid integrated circuit.

An advantage of the present invention is that an electro-acoustic circuit can be produced compactly.

Another advantage of the present invention is that the oscillation above 1 GHz can be performed.

### BRIEF DESCRIPTION OF THE DRAWINGS

These and other objects and features of the present invention will become clear from the following description taken in conjunction with the preferred embodiments thereof with reference to the accompanying drawings, and in which:

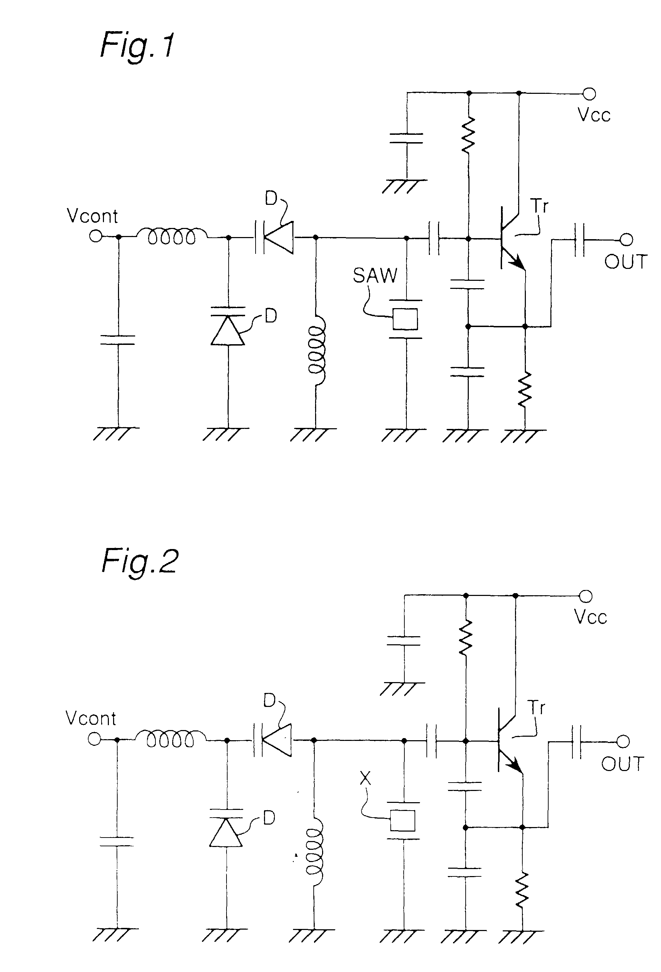

Fig. 1 is a circuit diagram of a voltage controlled oscillator with use of a surface wave resonator;
Fig. 2 is a circuit diagram of a voltage controlled oscillator with use of a quartz oscillator;

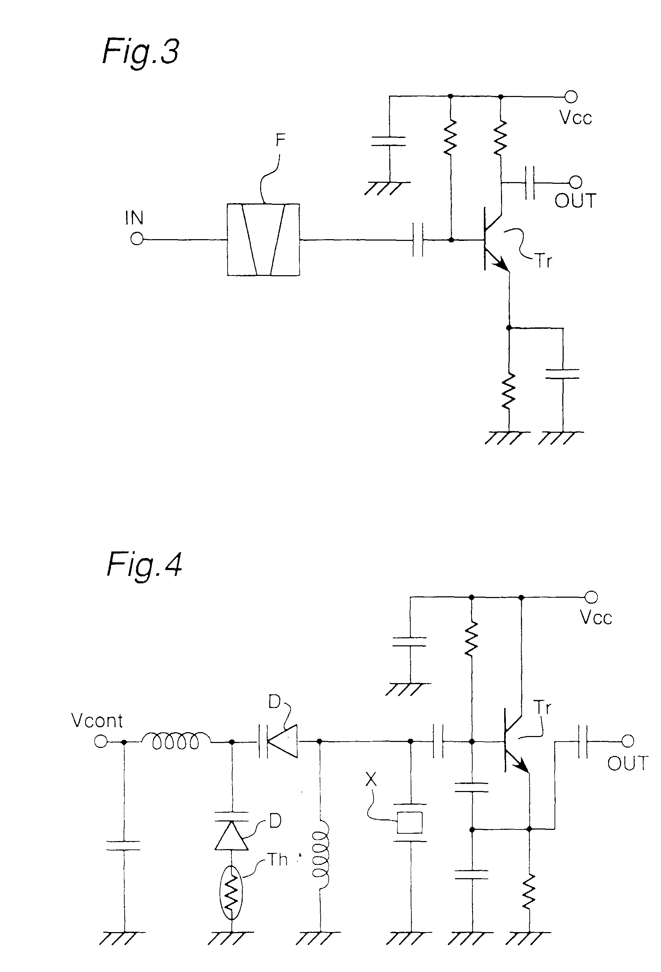

Fig. 3 is a circuit diagram of a high frequency amplifier;
Fig. 4 is a circuit diagram of a temperature compensated crystal oscillator;

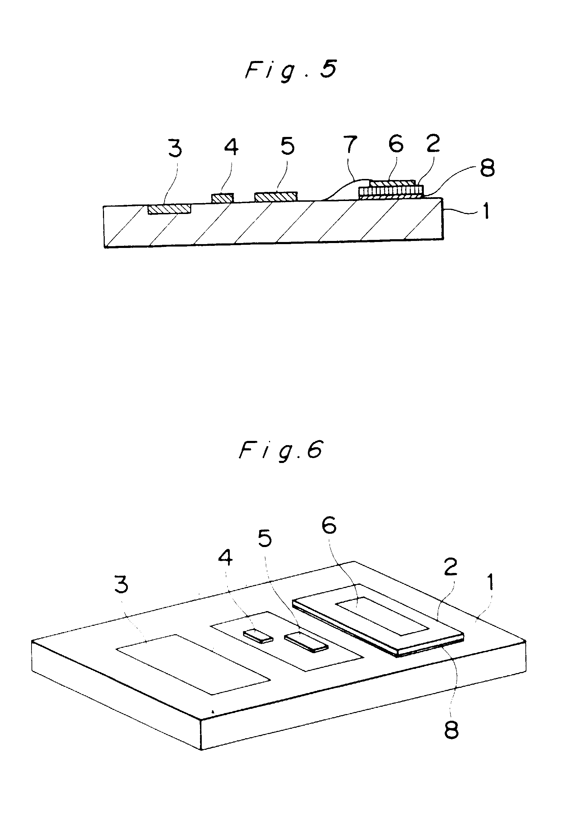

Fig. 5 is a sectional view of a structure of Embodiment 1 of the present invention;
Fig. 6 a perspective view of the structure of Embodiment 1;

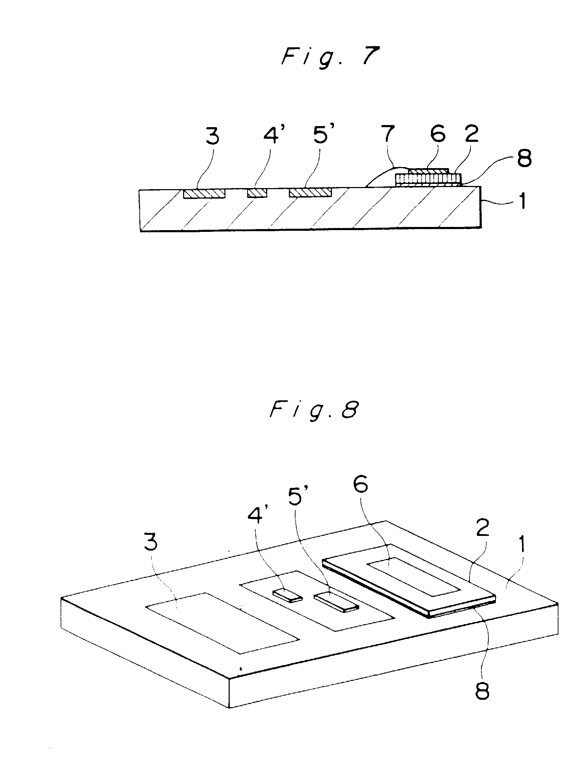

Fig. 7 is a sectional view of a structure of Embodiment 2 of the present invention;
Fig. 8 is a perspective view of the structure of Embodiment 2;

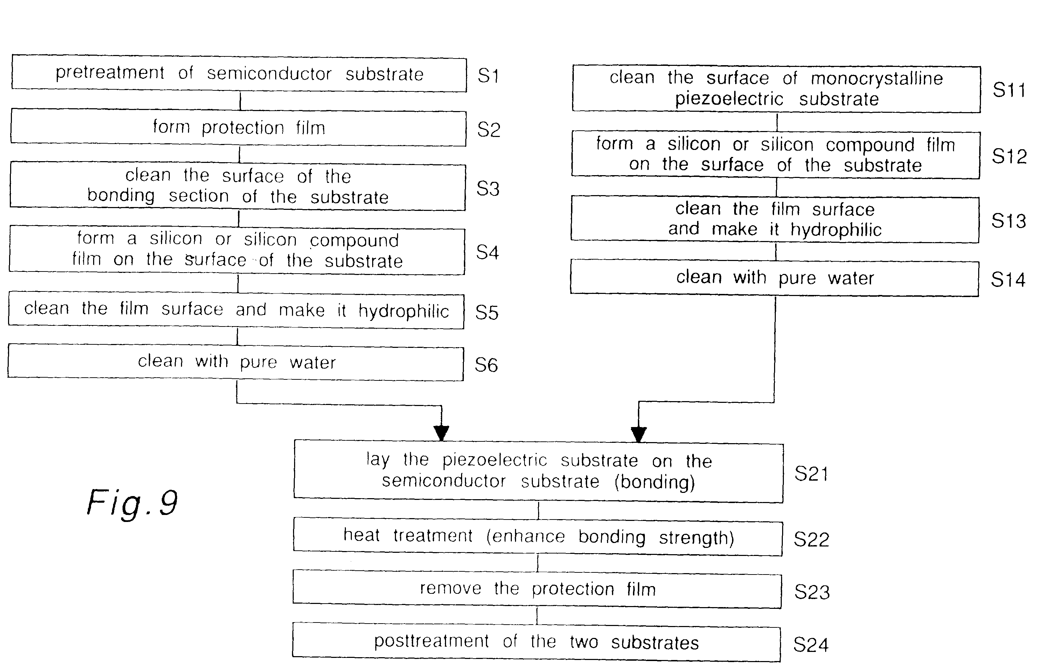

Fig. 9 is a flowchart of a manufacturing method of an electro-acoustic hybrid integrated circuit of Embodiment 3;

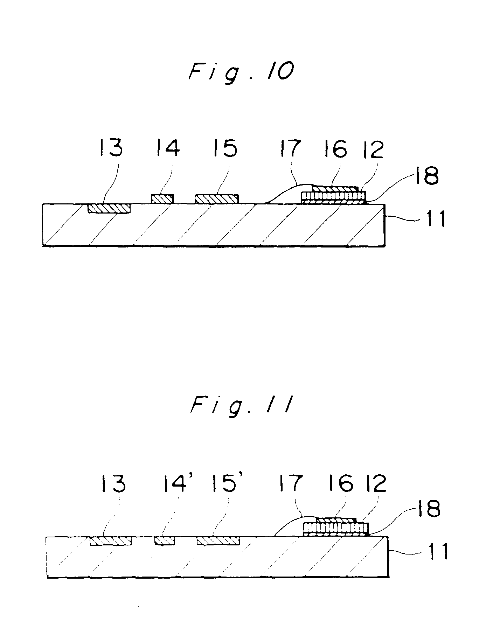

Fig. 10 is a sectional view of a structure of Embodiment 5 of the present invention;

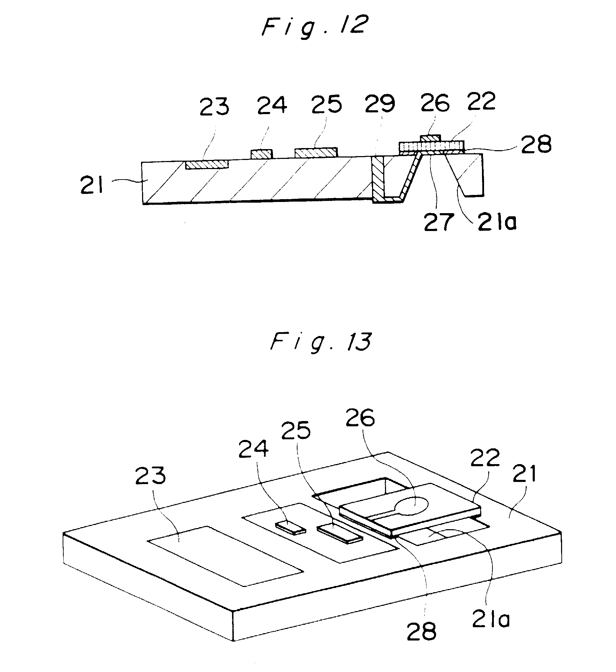

Fig. 11 is a sectional view of a structure of Embodiment 6 of the present invention;
Fig. 12 is a sectional view of a structure of Embodiment 9 of the present invention;
Fig. 13 a perspective view of the structure of Embodiment 9;

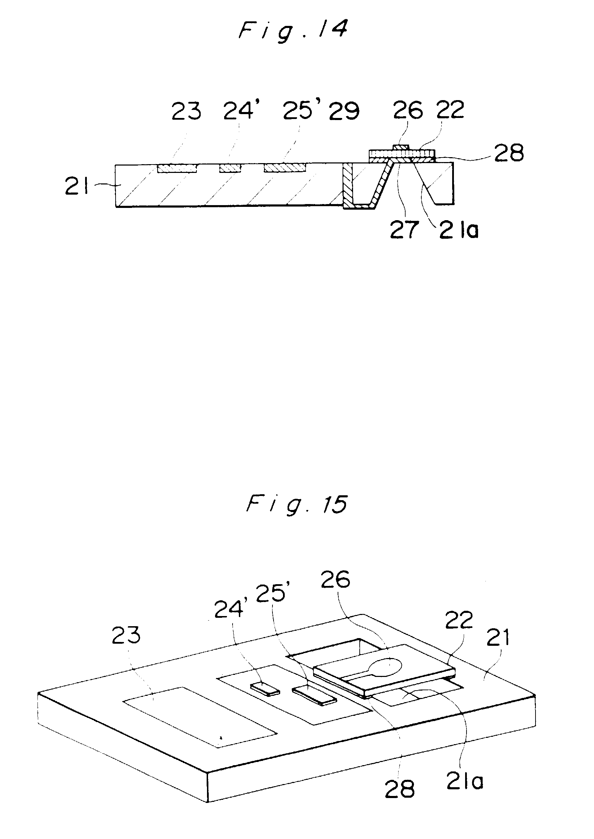

Fig. 14 is a sectional view of a structure of Embodiment 10 of the present invention;
Fig. 15 is a perspective view of the structure of Embodiment 10; and

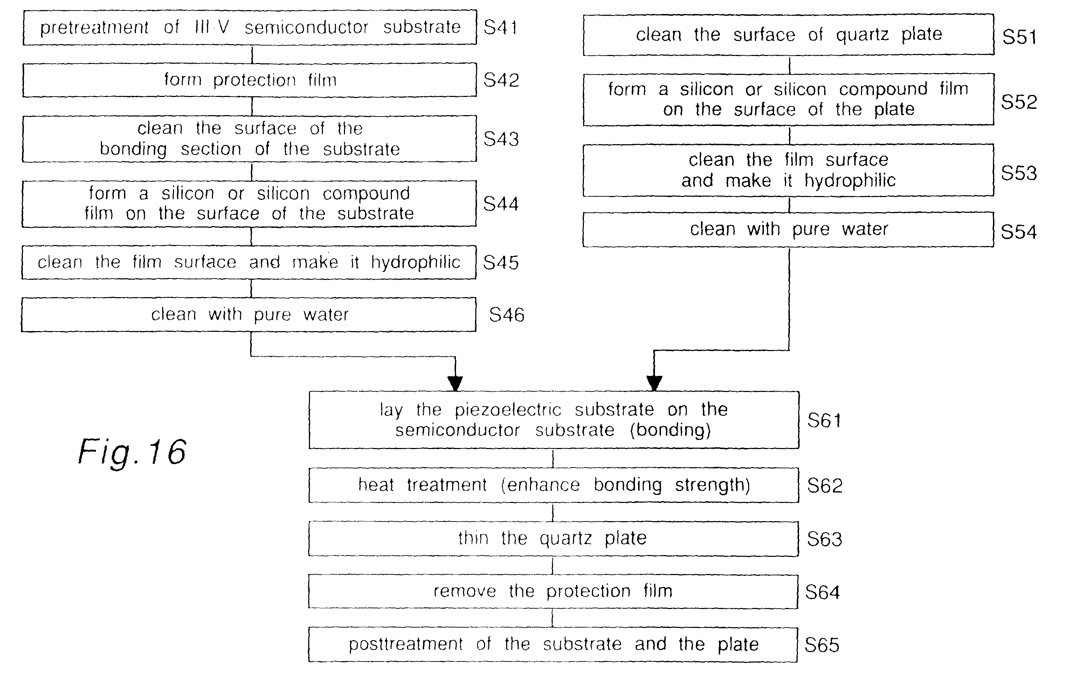

Fig. 16 is a flowchart of a manufacturing method of an electro-acoustic hybrid integrated circuit of Embodiment 11.

### DETAILED DESCRIPTION OF THE PREFERRED EMBODIMENTS

Referring now to the drawings, wherein like reference characters designate like or corresponding parts, electro-acoustic hybrid integrated circuits, especially of a voltage controlled oscillator, of embodiments of the present invention and manufacturing methods thereof will be explained below.

### Embodiment 1

Figs. 5 and 6 show the structure of a voltage controlled oscillator of Embodiment 1 of the present invention schematically, wherein the reference numeral 1 denotes a silicon (Si) substrate while the reference numeral 2 denotes a monocrystalline piezoelectric substrate or a lithium niobate or lithium tantalate substrate which constitutes a surface acoustic wave resonator (SAW). The reference numeral 8 denotes a silicon compound thin film such as a silicon oxide film or a silicon film deposited on the silicon substrate 1 and/or on the monocrystalline piezoelectric substrate 2, and the film thickness is 0.1 µm to several µm. The silicon substrate 1 bonds directly with the monocrystalline piezoelectric substrate 2 via the thin films 8. A silicon film may also be used for direct bonding instead of the silicon oxide film 8. The reference numeral 3 denotes a transistor formed on the silicon substrate 1 with photolithography process. Varactor diode chips (D) 4 with an electrostatic capacitance to vary with the applied voltage and passive chip components 5 such as capacitors, inductors and resistors are mounted on the silicon substrate 1. Comb-like electrodes 6 are provided on the monocrystalline piezoelectric substrate 2 to form the surface acoustic wave resonator, and wires 7 connect the electrodes 6 with the metallic lines on the silicon substrate 1. The components 2 - 5 mounted on the silicon substrate 1 and the two electrodes 6 are connected to form a voltage controlled oscillator. Further, the voltage controlled oscillator integrated on the silicon substrate 1 as a hybrid integrated circuit is sealed in a container (not shown).

The voltage controlled oscillator has for example a circuit shown in Fig. 1, and it comprises the transistor, the surface acoustic wave resonator (SAW) and the various electronics components 4, 5 such as varactor diodes (D). This is a known circuit and detailed explanation is omitted here. The oscillation frequency of the output OUT of the voltage controlled oscillator can be changed according to the voltage V_{cont} applied to the varactor diodes 4. Other circuits different from that shown in Fig. 1 may also be used. The numbers of varactor diodes and other passive electronics components vary with a circuit, and the arrangement thereof on the semiconductor substrate is designed suitably for each case.

As explained above, in this voltage-controlled oscillator, the oscillator circuit and the surface acoustic wave resonator are integrated on a semiconductor substrate as a hybrid integrated circuit. Thus, the volume decreases easily to about a tenth the counterpart of a prior art structure with a surface acoustic wave resonator sealed in a container is used, while the weight also decreases to about a fifth the counterpart of the prior art structure.

The direct bonding has further advantages. In the present invention, the silicon substrate and the monocrystalline piezoelectric substrate 2 are bonded directly via the silicon oxide thin films 8 formed on one or both of the surfaces of the substrates 1, 2. That is, the bonding is performed via inorganic substances, and the semiconductor process can be performed further after the bonding. On the contrary, if the semiconductor substrate 1 and the monocrystalline piezoelectric element 2 are bonded to each other with an ordinary bonding agent made from resin or the like, the semiconductor process cannot be performed further after the bonding owing to the worse heat resistance and the worse chemical resistance.

Further, if a bonding agent made from resin or the like is used, the degree of parallelization between the silicon substrate 1 and the lithium niobate or lithium tantalate substrate 2 becomes worse, and the precision of the size of the comb-type electrodes 6 formed with photolithography on the monocrystalline piezoelectric substrate 2 thereafter becomes worse. For example, if the resonance frequency is of the order of 1 GHz, the electrode size is required to be about 1 µm of line and space width. Therefore, when the parallelization is worse, a surface acoustic wave resonator for the submicrowave band cannot be operated. On the contrary, in this embodiment, the bonding is performed directly via the thin films 8, and the film preparation can be controlled in general in the order of one nanometer. Thus, the above-mentioned problem can be solved. This effect is especially advantageous at high frequencies.

If a bonding agent made from resin is used, the secular change is another problem due to the mechanical strain caused by the difference of thermal expansion coefficients between the resin as an organic material and the silicon substrate 1 and the monocrystalline piezoelectric substrate 2 both made of inorganic materials. However, the present embodiment solves this problem by bonding with inorganic materials.

### Embodiment 2

Figs. 7 and 8 show the structure of a voltage controlled oscillator of Embodiment 2 of the present invention schematically of the same circuit as Embodiment 1. The reference numerals 1 - 3 and 6 - 8 denote the same as in Embodiment 1. That is, the reference numeral 1 denotes a silicon substrate, while the reference numeral 2 denotes a monocrystalline piezoelectric substrate. The reference numeral 8 denotes a silicon compound film such as a silicon oxide film or a silicon film formed on the silicon substrate 1 and/or on the monocrystalline piezoelectric substrate 2 for direct bonding of the silicon substrate 1 with the monocrystalline piezoelectric substrate 2. The reference numeral 3 denotes a field effect transistor 3. The reference numeral 6 denotes an electrode of the surface acoustic wave resonator, and the reference numeral 7 denotes a wire connecting the electrode 6 with the metallic lines on the silicon substrate 1.

The reference numeral 4' denotes a varactor diode chip, while the reference numeral 5' denotes passive chip components such as capacitors. The components 3, 4', 5' and the two electrodes 6 are connected to form a voltage controlled oscillator shown in Fig. 3. Further, the voltage controlled oscillator integrated as a hybrid integrated circuit is sealed in a container (not shown).

This embodiment is different from Embodiment 1 in a point that the varactor diode chips 4' and the passive chip components 5' are formed with photolithography process in the silicon substrate 1 as known in a semiconductor process. It is easy to integrate the varactor diode chips 4' when the silicon substrate 1 is used. The resistors of the passive components 5' can be made easily by forming silicon resistors made by diffusion process or thin film resistors made from tantalum nitride; the capacitors can be made easily by forming silicon nitride films; and the inductors can be made easily by forming spiral metal patterns. By adopting this structure, the voltage controlled oscillator can be made more compactly than that of Embodiment 1. The mounting of the chip components 4, 5 needed in Embodiment 1 can be omitted in the manufacturing steps, and this is convenient for mass production.

### Embodiment 3

An embodiment of a manufacturing method of a voltage controlled oscillator is explained with reference to Fig. 9.

First, one or more depressed areas are formed in prescribed positions on a silicon substrate 1 with etching or the like, and a series of semiconductor process, including a diffusion process, necessary for a field effect transistor 3, varactor diodes 4 and the like is carried out at the heat treatment temperature for direct bonding or higher (step S1). The diffusion process is performed usually at a temperature as high as 1,000 °C or higher.

Next, a protection film is formed on the silicon section which has been subjected to the above-mentioned processes if necessary (step S2). The protection film is made of a metallic or oxide film which can resist the above-mentioned processes and can be removed finally. Then, the surface of a section used for the bonding later with a monocrystalline piezoelectric substrate 2 is cleaned very much (step S3). In concrete, the surface layer of silicon is etched and removed with a fluoric acid etchant.

Then, a first silicon oxide film 8 is formed on the silicon substrate 1 with a chemical vapor deposition process or the like (step S4). The film thickness of the silicon oxide and the uniformity of the films can be controlled easily for films of thickness of about 0.1 - 3 µm. The sputtering or the vacuum deposition may also be used.

The surface of the silicon oxide film 8 is cleaned with the buffered fluoric acid, and the surface is subjected to a processing to make it hydrophilic (step S5).

On the other hand, the surface of the monocrystalline piezoelectric substrate 2 is cleaned (step S11). Then, a second silicon oxide film 8 is also formed on the monocrystalline piezoelectric substrate 2 with a chemical vapor growth process or the like (step S12). The thickness and the uniformity of the second silicon oxide film 8 can be controlled similarly to the first silicon oxide film. The surface of the silicon oxide film 8 is cleaned with the buffered fluoric acid, and the surface is subjected to a processing to make it hydrophilic (step S13).

Then, the surface of the first and second silicon oxide films 8 are cleaned sufficiently with pure water (steps S6 and S14). Next, the surfaces of the two silicon oxide films 8 are contacted uniformly immediately (step S21). Thus, in this intermediate step the bonding between the silicon substrate 1 and the monocrystalline piezoelectric substrate 2 is due to constituent components of water such as hydroxy groups absorbed on the surfaces of the silicon oxide films 8. The as-formed bonding is sufficiently hard.

The bonding strength becomes harder by the heat treatment at 100 - 800 °C, preferably at 300 - 600 °C (step S22). When the heat treatment temperature is high, the shape, the size or the like of the monocrystalline piezoelectric substrate 2 is limited somewhat due to the difference of the thermal expansion coefficients between the silicon substrate 1 and the monocrystalline piezoelectric substrate 2. However, the bonding strength can be improved essentially, without causing peel-off materials and damages, when the thickness and the area of the monocrystalline piezoelectric substrate 2 are decreased with increase in the heat treatment temperature.

As to the effect of the heat treatment on the bonding strength, for example the heat treatment of one hour at 200 °C can increase the bonding strength several times, to several tens kg/cm². If the temperature is increased above 800 °C, lithium atoms leave for the surface of lithium niobate or lithium tantalate. Thus, the surface characteristic is deteriorated ant the prescribed performance as a surface acoustic wave resonator cannot be obtained. Therefore, the bonding temperature has to be 800 °C or lower when lithium niobate or lithium tantalate is used for the monocrystalline piezoelectric substrate 2.

Next, the protection film is removed if it is formed in step S2 (step S23). Then, various processes such as electrode formation which are processed at temperatures below the heat treatment temperature for bonding. Then, electrodes are formed on the surface of the monocrystalline piezoelectric substrate with vacuum deposition or the like, and then the metal pattern is formed with a conventional photolithography (step S24). The electrodes are made from aluminum, gold/chromium or the like.

The mechanism of direct bonding is considered as follows: The bonding is caused initially by the Van der Waals force of the hydroxy groups or the like absorbed on the surface of the silicon oxide films. Then, hydrogen atoms or the like as a constituent element of water is extracted from the bonding interface on the heat treatment, while the silicon and oxygen atoms in the silicon oxide films, silicon atoms at the silicon surface and oxygen atoms in the monocrystalline piezoelectric substrate 2 are bonded to increase the bonding strength. Therefore, the direct bonding is possible even if a silicon oxide film 8 is formed only one of the substrates 1, 2, that is, only on the surface of the monocrystalline piezoelectric substrate 2 or of the silicon substrate 1. The bonding is also possible if the monocrystalline piezoelectric substrate 2 is made from an oxide other than lithium niobate or lithium tantalate. The bonding temperature can be lowered by applying an electric voltage at the bonding interface.

The bonding is possible at room temperature and it can be carried out after all processes are completed.

If a controlled voltage oscillator of Embodiment 2 is manufactured, the varactor diodes 4' and the passive electronics components are fabricated in steps S1 and S24.

### Embodiment 4

A second example of a manufacturing method of a voltage controlled oscillator is explained with reference to Fig. 9. In this example, an amorphous silicon film is used for the film 8.

Similarly to Embodiment 3, one or more depressed areas are formed in prescribed positions on a silicon substrate 1 with etching or the like, and a series of semiconductor process, including a diffusion process, necessary for a field effect transistor 3, varactor diodes 4 and the like is carried out at the heat treatment temperature for direct bonding or higher (step S1). Next, a protection film is formed on the silicon section which has been subjected to the above-mentioned processes if necessary (step S2). Then, the surface of a section for direct bonding is cleaned very much (step S3). Then, a first amorphous silicon thin film 8 is formed on the silicon substrate 1 with a plasma chemical vapor deposition process or the like (step S4). The film thickness of the amorphous silicon is about 0.1 - 3 µm as in Embodiment 3. The surface of the amorphous silicon film 8 is cleaned with the buffered fluoric acid, and the surface is subjected to a hydrophilic treatment to make it hydrophilic (step S5).

On the other hand, the surface of the monocrystalline piezoelectric substrate 2 is cleaned (step S11). Then, a second amorphous silicon thin film 8 of thickness of 0.1 - 0.3 µm is also formed on the monocrystalline piezoelectric substrate 2 with a plasma chemical vapor deposition process or the like (step S12). The surface of the amorphous silicon film 8 is cleaned with the buffered fluoric acid, and the surface is subjected to a processing to make it hydrophilic (step S13).

Then, the surfaces of the first and second amorphous silicon films are cleaned sufficiently with pure water (step S14). Next, the surfaces of the two amorphous silicon films 8 are contacted uniformly immediately (step S21). Thus, in this intermediate step the bonding between the silicon substrate 1 and the monocrystalline piezoelectric substrate 2 is due to constituent components of water such as hydroxy groups absorbed on the surfaces of the amorphous silicon films 8. The as-formed bonding is sufficiently hard.

The bonding becomes harder by the heat treatment at 100 - 800 °C, preferably at 300 - 600 °C (step S22). Next, the protection film is removed if it is formed in step S2 (step S23). Then, various processes such as electrode formation which are processed at temperatures below the heat treatment temperature for bonding. Then, electrodes are formed on the surface of the monocrystalline piezoelectric substrate with vacuum deposition or the like, and then the metal pattern is formed with a conventional photolithography (step S24). The electrodes are made from aluminum, gold/chromium or the like.

The bonding strength with use of amorphous silicon films is larger than that of Embodiment 3 with use of silicon oxide films. Because the direct bonding is possible at room temperature, the bonding process (step S21) may be carried out after all processing is completed.

The mechanism of direct bonding is considered similar to that of Embodiment 3 as follows: The bonding is caused initially by the Van der Waals force of the hydroxy groups or the like absorbed on the surface of the amorphous silicon films. Then, hydrogen atoms or the like as a constituent element of water is extracted from the bonding interface on the heat treatment, while the silicon atoms in the amorphous silicon films, silicon atoms at the silicon substrate surface and oxygen atoms in the monocrystalline piezoelectric substrate 2 are bonded to increase the bonding strength. Therefore, the direct bonding is possible even if an amorphous silicon film 8 is formed only one of the substrates 1, 2, that is, only on the surface of the monocrystalline piezoelectric substrate 2 or of the silicon substrate 1. The bonding is also possible if the monocrystalline piezoelectric substrate 2 is made from an oxide other than lithium niobate or lithium tantalate. The bonding temperature can be lowered by applying an electric voltage at the bonding interface.

### Embodiment 5

Fig. 10 show a third example of the structure of a voltage controlled oscillator of the present invention. The perspective view of the voltage controlled osillator is similar to Fig. 6 and it is not shown here. The reference numeral 11 denotes a GaAs substrate as a representative of III-V group compound semiconductors while the reference numeral 12 denotes a monocrystalline piezoelectric substrate or a lithium niobate or lithium tantalate substrate which constitutes a surface acoustic wave resonator (SAW). The reference numeral 18 denotes a silicon compound film such as a silicon oxide film or a silicon film formed on the GaAs substrate 11 and/or on the monocrystalline piezoelectric substrate 12, and the film 18 bonds the GaAs substrate 11 directly with the monocrystalline piezoelectric substrate 12 via the films 18. A transistor 13 is formed on the GaAs substrate 1. Varactor diode chips (D) 14 with an electrostatic capacitance to vary with the applied voltage and passive chip components 15 such as capacitors, inductors and resistors are mounted on the GaAs substrate 11. Comb-like electrodes 16 are provided on the monocrystalline piezoelectric substrate 12 to form the surface acoustic wave resonator, and wires 17 connect the electrodes 16 with the metallic lines on the GaAs substrate 11. The components 12 - 15 mounted on the GaAs substrate 11 and the two electrodes 16 are connected to form a voltage controlled oscillator as shown in Fig. 1. A voltage-controlled oscillator comprises the transistor, the various electronics components 14, 15 and the surface acoustic wave resonator (SAW). Further, the voltage controlled oscillator integrated as a hybrid integrated circuit is sealed in a container (not shown).

Similarly to Embodiment 1, by using this structure, the oscillator circuit and the surface acoustic wave resonator are integrated as a hybrid integrated circuit. Thus, the volume decreases easily to about a tenth the counterpart of a prior art structure wherein a surface acoustic wave resonator put in a closed container is used, while the weight also decreases to about a fifth the counterpart of the prior art structure. The above-mentioned problems with use of a bonding agent made from resin can also be avoided.

This embodiment is different from Embodiment 1 in a point that the GaAS substrate 11 is used instead of the silicon substrate 1. III-V group compound semiconductors such as GaAs, InP and InGaAs have a larger mobility than silicon generally. The mobility of GaAs is about six times that of silicon. Therefore, a high speed semiconductor can be formed by using a III-V compound semiconductor, and a transistor which can be operated at several tens GHz can be formed easily. Thus, the operation at higher frequencies of an electro-acoustic hybrid integrated circuit becomes possible, and the voltage controlled oscillator of this embodiment can be operated at higher frequencies than that of Embodiment 1.

### Embodiment 6

Fig. 11 shows a fourth example of the structure of a voltage controlled oscillator of the present invention. The perspective view of the voltage controlled oscillator is similar to Fig. 6 and it is not shown here. The reference numerals 11 - 13 and 16 -18 denote the same as in Embodiment 5 (Fig. 10). The silicon oxide or silicon film 18 bonds the GaAs substrate 11 and the monocrystalline piezoelectric substrate 12 directly. The reference numeral 14' denotes a varactor diode chip which changes the electrostatic capacitance with the applied voltage, and the reference numeral 15' denotes passive chip components such as capacitors, inductors and resistors. The components on the GaAs substrate and the two electrodes of the surface acoustic wave resonator are connected to form a voltage controlled oscillator as shown in Fig. 1. The voltage controlled oscillator constructed integrated as explained above is put in a container (not shown).

This embodiment is different from Embodiment 5 in a point that the varactor diode chip 14' and the passive chip components 15' are made on the GaAs substrate 11 as a body integrally, similarly to Embodiment 2. It is easy to integrate the varactor diode chips 14' when the GaAs substrate 11 is used. The resistors can be made easily by forming GaAs resistors made by a diffusion process or thin film resistors made from tantalum nitride. The capacitors can be made easily by forming silicon nitride films, and the inductors can be made easily by forming a spiral metal pattern. By adopting this structure, the voltage controlled oscillator can be made more compactly than that of Embodiment 5. The mounting of the chip components are not needed, and this makes mass production easy.

### Embodiment 7

A third example of a manufacturing method of voltage controlled oscillator of the present embodiment is explained with reference to Fig. 9.

First, one or more depressed areas are formed in prescribed positions on a GaAs substrate 11 with etching or the like, and a series of semiconductor process, including a diffusion process, necessary for a field effect transistor 13, varactor diodes 14 and the like is carried out at the heat treatment temperature for direct bonding or higher (step S1).

Next, a protection film is formed on the GaAS section which has been subjected to the above-mentioned processes if necessary (step S2). The protection film is made of a metallic or oxide film which can resist the above-mentioned processes and can be removed finally. Then, the surface of a GaAs section used for the bonding later is cleaned very much (step S3). In concrete, the surface layer of GaAs is etched and removed with a fluoric acid etchant.

Then, a first silicon oxide thin film 18 is formed on the GaAs substrate 11 with a chemical vapor deposition process or the like (step 54). The film thickness of the silicon oxide film can be controlled easily about 0.1 - 3 µm.

The surface of the silicon oxide film 18 is cleaned with the buffered fluoric acid, and the surface is subjected to a hydrophilic treatment to make it hydrophilic (step S5).

On the other hand, the surface of the monocrystalline piezoelectric substrate 12 is cleaned (step S11). Then, a second silicon oxide thin film 18 is also formed on the monocrystalline piezoelectric substrate 12 with a chemical vapor growth process or the like (step S12). The thickness and the uniformity of the second silicon oxide film 18 can be controlled similarly to the first silicon oxide film.

The surface of the silicon oxide film 18 is cleaned with the buffered fluoric acid, and the surface is subjected to a processing to make it hydrophilic (step S13).

Then, the surface of the first and second silicon oxide films 18 are cleaned sufficiently with pure water (steps 56 and S14). Next, the surfaces of the two silicon oxide films 18 are contacted uniformly immediately (step S21). Thus, in this intermediate step the bonding between the GaAs substrate 11 and the monocrystalline piezoelectric substrate 12 is due to constituent components of water such as hydroxy groups absorbed on the surfaces of the silicon oxide films 18. The as-formed bonding is sufficiently hard.

The bonding becomes harder by the heat treatment at 100 - 800 °C, preferably at 300 - 600 °C (step S22). When the heat treatment temperature is high, the ranges of the shape, the size or the like of the monocrystalline piezoelectric substrate 12 is limited somewhat due to the difference of the thermal expansion coefficients between the GaAs substrate 11 and the monocrystalline piezoelectric substrate 12. However, the bonding strength can be improved essentially, without causing peel-off materials and damages, when the thickness and the area of the monocrystalline piezoelectric substrate 12 are decreased with increase in the heat treatment temperature.

The effect of the heat treatment on the bonding strength is similar to Example 3. If the temperature is increased above 800 °C, lithium atoms leave from the surface of lithium niobate or lithium tantalate. Thus, the surface characteristic is deteriorated and the prescribed performance as a surface acoustic wave resonator cannot be obtained. Therefore, the bonding temperature has to be 800 °C or lower when lithium niobate or lithium tantalate is used for the monocrystalline piezoelectric substrate 2.

Next, the protection film is removed if it is formed in step S2 (step S23). Then, various processes such as electrode formation which are processed at temperatures below the heat treatment temperature for bonding. Then, electrodes are formed on the surface of the monocrystalline piezoelectric substrate with vacuum deposition or the like, and then the metal pattern is formed with a conventional photolithography (step S24). The electrodes are made from aluminum, gold/chromium or the like. Thus, the structure of Embodiment 5 can be manufactured by using a method similar to Embodiment 3.

The mechanism of direct bonding is considered similar to Embodiment 3. The bonding is caused initially by the Van der Waals force of the hydroxy groups or the like absorbed on the surface of the silicon oxide films. Then, hydrogen atoms or the like as a constituent element of water is extracted from the bonding interface on the heat treatment, while the silicon and oxygen atoms in the silicon oxide films, oxygen atoms at the GaAs surface and oxygen atoms in the monocrystalline piezoelectric substrate 12 are bonded to increase the bonding strength. Therefore, the direct bonding is possible even if a silicon oxide film 18 is formed only one of the substrates 11, 12, that is, only on the surface of the monocrystalline piezoelectric substrate 12 or of the GaAs substrate 11. The bonding is also possible if the monocrystalline piezoelectric substrate 12 is made from an oxide other than lithium niobate or lithium tantalate. Further, the bonding is also possible by using silicon oxide films when a III-V compound substrate other than GaAs substrate is used.

### Embodiment 8

A fourth example of a manufacturing method of voltage controlled oscillator is explained with reference to Fig. 9. In this example, an amorphous silicon film is used for the film 18.

Similarly to Embodiment 7, one or more depressed areas are formed in prescribed positions on a GaAs substrate 11 with etching or the like, and a series of semiconductor process, including a diffusion process, necessary for a field effect transistor 13, varactor diodes 14 and the like is carried out at the heat treatment temperature for direct bonding or higher (step S1). Next, a protection film is formed on the GaAs section which has been subjected to the above-mentioned processes if necessary (step S2). Then, the surface of a GaAs section used for bonding later is cleaned very much (step S3). In concrete, the surface layer of GaAs is etched and removed with a fluoric acid etchant.

Then, a first amorphous silicon thin film 18 is formed on the GaAs substrate 11 with a plasma chemical vapor deposition process or the like (step S4). The film thickness of the amorphous film is about 0.1 - 3 µm as in Embodiment 7. The surface of the silicon oxide film 18 is cleaned with the buffered fluoric acid, and the surface is subjected to a hydrophilic treatment make it hydrophilic (step S5).

On the other hand, the surface of the monocrystalline piezoelectric substrate 12 is cleaned (step S11). Then, a second amorphous silicon thin film 18 of thickness of 0.1 - 0.3 µm is also formed on the monocrystalline piezoelectric substrate 12 with a plasma chemical vapor deposition process or the like (step S12). The surface of the silicon oxide film 8 is cleaned with the buffered fluoric acid, and the surface is subjected to a processing to make it hydrophilic (step S13).

Then, the surfaces of the first and second amorphous oxide films are cleaned sufficiently with pure water (step S14). Next, the surfaces of the two amorphous silicon films 8 are contacted uniformly immediately (step S21). Thus, in this intermediate step the bonding between the GaAs substrate 11 and the monocrystalline piezoelectric substrate 12 is due to constituent components of water such as hydroxy groups absorbed on the surfaces of the amorphous silicon films 18. The as-formed bonding is sufficiently hard.

Finally, steps S22 - S24 are performed to form an electro-acoustic hybrid integrated circuit wherein the GaAs substrate 11 and the electro-acoustic element are integrated.

The mechanism of direct bonding is considered similar to Embodiment 7. Therefore, the direct bonding is possible even if an amorphous silicon film 18 is formed only on one of the substrates 11, 12, that is, only on the surface of the monocrystalline piezoelectric substrate 12 or of the GaAs substrate 11. The bonding is also possible if the monocrystalline piezoelectric substrate 12 is made from an oxide other than lithium niobate or lithium tantalate.

### Embodiment 9

Figs. 12 and 13 show a fifth example of the structure of a voltage controlled oscillator of the present invention, wherein the reference numeral 21 denotes a GaAs substrate, the reference numeral 22 denotes a quartz oscillator bonded to the GaAs substrate 21, the reference numeral 23 denotes a transistor formed on the GaAs substrate 21, the reference numeral 24 denotes a varactor diode chip which changes the electrostatic capacitance with the applied voltage, the reference numeral 25 denotes passive chip components such as capacitors, inductors and resistors, the reference numeral 26 denotes an upper electrode of the quartz oscillator 22 and the reference numeral 27 denotes a lower electrode arranged at the back side of the quartz oscillator 22. A throughhole 21a is provided in the GaAs substrate 21 just below the quartz oscillator 22 in order to connect the lower electrode 27 to the back side of the quartz oscillator 22. The lower electrode 27 is connected electrically with the metal lines on the GaAs substrate 21 through a viahole 29 (or a throughhole formed in the substrate 21, covered with a conductor on the inside of the throughhole, to connect both sides of the substrate 21 electrically) or the like. Further, the components of the GaAs substrate 21 and the two electrodes of the quartz oscillator 22 are connected to form a voltage controlled oscillator as shown in Fig. 13. The reference numeral 28 denotes a silicon oxide film or a silicon film formed on the GaAs substrate 21 and/or on the quartz oscillator 22 (except an area in correspondence to the throughhole 21a) to bond the GaAs substrate 21 and the quartz oscillator 22 directly. Further, the voltage controlled oscillator is sealed in a closed container (not shown). The field effect transistor, the various electronics components and the quartz oscillator 22 constructs an oscillator shown in Fig. 2.

By adopting this structure, the volume decreases to about a tenth the counterpart of a prior art structure wherein a quartz oscillator put in a container is used, while the weight also decreases to about a fifth the counterpart of the prior art structure.

In this Embodiment, the GaAs substrate 21 and the quartz (a single crystal of silicon oxide) 22 are bonded directly by using the silicon oxide at the surface of the quartz itself and the silicon oxide or silicon films formed on the GaAs substrate and/or on the quartz, without using an ordinary bonding agent made from resin or the like. That is, the bonding is due to inorganic substances. Thus, advantages similar to Embodiment 3 can be obtained.

Other voltage controlled oscillator circuits different from that shown in Fig. 2 may also be used. The numbers of varactor diodes and other passive electronics components vary with each circuit, and the arrangement thereof on the semiconductor substrate is designed suitably for each case.

### Embodiment 10

Figs. 14 and 15 show a sixth example of the structure of a voltage controlled oscillator of the present invention, wherein the reference numerals 21 - 23 and 26 - 29 denote the same as in Example 9. The reference numeral 24' denotes a varactor diode chip which changes the electrostatic capacitance with the applied voltage, and the reference numeral 25' denotes passive chip components such as capacitors, inductors and resistors. The lower electrode 24 is connected with the metal lines on the GaAs substrate 21 through a viahole 29. Further, the components of the GaAs substrate 21 and the two electrodes of the quartz oscillator 22 are connected to form a voltage controlled oscillator. The voltage controlled oscillator constructed as explained above is sealed in a closed container (not shown).

This embodiment is different from Embodiment 9 in a point that the varactor diode chip 24' and the passive chip components 25' are integrated directly in the GaAs substrate 21 as in Embodiment 6. By adopting this structure, the voltage controlled oscillator can be made more compactly than that of Embodiment 9. The mounting of the chip components 24', 25' are not needed, similarly to Embodiment 6, and this makes mass production easy.

### Embodiment 11

A fifth example of a manufacturing method of voltage controlled oscillator of the present embodiment is explained with reference to Fig. 16.

First, one or more depressed areas are formed in prescribed positions on a GaAs substrate 21 as an example of III-V compound semiconductor with etching or the like, and a series of semiconductor process, including a diffusion process, necessary for a field effect transistor 23, varactor diodes 24 and the like is carried out at the heat treatment temperature for direct bonding or higher (step S41). The diffusion process is performed usually at a temperature as high as 870 °C or higher.

Next, a protection film is formed on the GaAs section which has been subjected to the above-mentioned processes if necessary (step S42). The protection film is made of a metallic or oxide film which can resist the above-mentioned processes and can be removed finally. Then, the surface of a section for direct bonding is cleaned very much (step S43). In concrete, the surface layer of GaAs is etched and removed with a fluoric acid etchant.

Then, a first silicon oxide thin film 28 is formed on an area on the GaAs substrate 21 with a chemical vapor growth process or the like (step S44). The film thickness of the silicon oxide and the uniformity of the films can be controlled easily for films of thickness of about 0.1 - 3 µm.

The surface of the silicon oxide film 28 is cleaned with the buffered fluoric acid, and the surface is subjected to a hydrophilic treatment to make it hydrophilic (step S45).

On the other hand, the surface of the quartz oscillator 22 is cleaned (step S51). Then, a second silicon oxide thin film 28 is also formed on the quartz oscillator 2 with a chemical vapor growth process or the like (step S52). The thickness and the uniformity of the second silicon oxide film 28 can be controlled similarly to the first silicon oxide film.

The surface of the silicon oxide film 28 is cleaned with the buffered fluoric acid, and the surface is subjected to a processing to make it hydrophilic (step S53).

Then, the surface of the first and second silicon oxide films 28 are cleaned sufficiently with pure water (steps S46 and S54). Next, the surfaces of the two silicon oxide films 28 are contacted uniformly immediately (step S61). Thus, in this intermediate step the bonding between the silicon substrate 21 and the quartz oscillator 22 is due to constituent components of water such as hydroxy groups absorbed on the surfaces of the silicon oxide films 28. The as-formed bonding is sufficiently hard.

The bonding becomes harder by the heat treatment at 100 - 860 °C, preferably at 300 - 600 °C (step S62). When the heat treatment temperature is high, the ranges of the shape, the size or the like of the quartz oscillator 22 is limited somewhat due to the difference of the thermal expansion coefficients between the silicon substrate 21 and the quartz oscillator 22. However, the bonding strength can be improved essentially, without causing peel-off materials and damages, when the thickness and the area of the quartz oscillator 22 are decreased with increase in the heat treatment temperature.

As to the effect of the heat treatment on the bonding strength, for example the heat treatment of one hour at 200 °C can increase the bonding strength several times, to several tens kg/cm². If the temperature is increased above 870 °C, the crystal structure of quartz changes. Therefore, the bonding temperature has to be 860 °C or lower.

The mechanism of direct bonding is considered similar to Embodiment 7.

Then, if necessary, the quartz substrate is thinned as explained in Embodiment 12 (step S63).

Next, a hole 21a is formed just below the quartz oscillator 22, and the silicon oxide film 28 exposed through the hole 21a etch away after the remaining part is covered with a resist or the like. Then, the resist and the protection film, if the protection film is formed in step S42, are removed (step S64). Then, various processes such as electrode formation which are processed at temperatures below the heat treatment temperature for bonding and below 860 °C. Then, electrodes 23, 24 are formed on the two surfaces of the quartz oscillator 22 with vacuum deposition or the like, and then the metal pattern is formed with a conventional photolithography (step S65). The electrodes are made from aluminum, gold/chromium or the like.

### Embodiment 12

A sixth example of a manufacturing method of voltage controlled oscillator is explained with reference to Fig. 16.

Similarly to Embodiment 11, after at least an active element is formed on a prescribed recess, the bonding with a quartz plate 21 is performed (steps S61 and S62). Next, the quartz oscillator 22 is processed to decrease the thickness with polishing or etching (step S63). Thus, for example, a quartz substrate of initial thickness of 200 µm can be formed easily to have the thickness of 5 µm or less. If a precise etching process is used, the quartz plate can be made thin further to thickness of 1 µm. If quartz AT cut is used, the thickness of 1 µm makes it possible to oscillate at about 1.6 GHz of fundamental wave. Then, by performing processes (steps S64, S65) similar to those of Embodiment 11, a voltage controlled oscillator which integrates the GaAs substrate 21 and the quartz oscillator 22 can be produced.

Such a voltage controlled oscillator can oscillate at a frequency as high as 1.6 GHz which cannot be realized previously. Especially, if a GaAs substrate 22 is used, a transistor which operates at frequencies higher by several times than a silicon transistor, the thin quartz oscillator is very advantageous at a high frequency region of 1 GHz or higher.

Further, if the frequency exceeds 1 GHz, the long metallic lines deteriorates the high frequency characteristic. However, the integration according to this Embodiment can improves the performance.

### Embodiment 13

A seventh example of a manufacturing method of voltage controlled oscillator is explained with reference to Fig. 16. In this example, an amorphous silicon thin film is used for direct bonding.

Similarly to Embodiment 11, after at least an active element is formed on a prescribed recess, an amorphous silicon film is formed with plasma CVD or the like at least on the GaAs substrate as a bonding plane (step S44). The film thickness of the amorphous silicon is about 0.1 - 3 µm, similarly to Embodiment 11. Then, the surfaces of the amorphous silicon film 28 and of the quartz oscillator 22 are made very clean (steps S45 and S53). The cleaning process is roughly similar to Embodiment 11. The silicon surface is cleaned with an etchant of buffered fluoric acid. Then, the two surfaces are cleaned with pure water sufficiently and they are layered uniformly immediately (steps S46, S54 and S61). Then, the bonding is enhanced by heat treatment. Thus, the direct bonding can be realized easily. Next, the quartz plate can be thinned further if necessary with polishing or etching similarly to in Embodiment 12. Then, by performing processes similar to those of Embodiment 11 (steps S62 - 65), a voltage controlled oscillator which integrates the GaAs substrate and the quartz oscillator can be produced, and advantages similar to Embodiments 11 and 12 can be obtained. The bonding is possible at room temperature, and it can be carried out after all processes are completed.

The mechanism of direct bonding is similar to Embodiment 7. Therefore, the direct bonding is possible even if a silicon oxide film is formed only one of the substrates 21, 22, that is, only on the surface of the quartz plate 22 or of the silicon substrate 21. A lithium niobate or lithium tantalate may also be used instead of the quartz oscillator.

As a silicon compound for direct bonding, a silicon oxide is used in the embodiments mentioned above. Silicon oxide films prepared by a chemical vapor deposition process varies somewhat with the conditions of the deposition. Nitrogen atoms may also be included in a silicon oxide film. However, direct bonding is possible in these cases. The possibility of direct bonding relates to the bonding characteristics of the relevant materials, and it is considered that a material having covalent bond characteristic such as silicon or silicon oxide is considered to show similar effects.

Though the above-mentioned embodiments relate voltage controlled oscillators, it is apparent that the present invention can be applied not only to a voltage controlled oscillator but also to other electro-acoustic circuits such as a high frequency amplifier (Fig. 3) and a temperature compensated crystal oscillator (Fig. 4) by bonding an electro-acoustic element (F, X) directly to a semiconductor substrate for a transistor element.

The hybrid integrate circuits and the manufacturing methods of the embodiments have the advantages explained below.

Because fundamental elements of a transistor and an electro-acoustic element such as a surface acoustic wave resonator for generating oscillation are integrated as one body, the size and the weight of an electro-acoustic circuit can be reduced to a large extent.

Because a semiconductor substrate and an electro-acoustic element are bonded directly with a film of an inorganic material of silicon or the like having a controlled film thickness, the planar property is very good, and the submicron photolithography necessary for the setting of oscillation frequency can be used. Further, the reliability on heat and vibration can be improved to a large extent.

If polishing or etching processing of quartz as shown in Embodiment 12 is performed, the thickness can be decreased to 5 µm or less easily. Therefore, a voltage controlled oscillator of a fundamental wave in the submicrowave band (several hundreds MHz to several GHz) can be manufactured easily. Then, the voltage controlled oscillator can have better performance at a lower cost.

When the integration is performed on a GaAs substrate, the high frequency characteristic of a transistor made on a substrate can be improved several time than a case with use of a silicon transistor. Then, the performance as a voltage controlled oscillator can be extended to higher frequencies.

The bonding at room temperature is essentially possible, and the degree of freedom of the manufacturing processes is vary large. This is favorable for the mass production.

Although the present invention has been fully described in connection with the preferred embodiments thereof with reference to the accompanying drawings, it is to be noted that various changes and modifications are apparent to those skilled in the art. Such changes and modifications are to be understood as included within the scope of the present invention as defined by the appended claims unless they depart therefrom.

## Claims

1. An integrated unitary body for use in an electronic device, especially in an electro-acoustic hybrid integrated circuit,
comprising:
a semiconductor substrate (1; 11; 21);
a single crystalline piezoelectric substrate (2; 12; 22); and
a film (8; 18; 28) including silicon between said semiconductor substrate (1; 11; 21) and said single crystalline piezoelectric substrate (2; 12; 22);
characterized in that said semiconductor substrate (1; 11; 21) and said piezoelectric substrate (2; 12; 22) are directly bonded via said film (8; 18; 28) without any organic adhesives, wherein the bonding between said film (8; 18; 28) and said semiconductor substrate (1; 11; 21) is between component atoms of said film and oxygen and/or component atoms of said semiconductor substrate (1; 11; 21) and wherein the bonding between said film (8; 18; 28) and said piezoelectric substrate (2; 12; 22) is between component atoms of said film (8; 18; 28) and oxygen atoms of said piezoelectric substrate (2; 12; 22).

2. An integrated unitary body according claim 1,
wherein said semiconductor substrate (1; 11; 21) is made from silicon.

3. An integrated unitary body according to claim 1, wherein said semiconductor substrate (1; 11; 21) is made from a III-V compound semiconductor.

4. An integrated unitary body according to claim 3,
wherein said III-V compound semiconductor is GaAs.

5. An integrated unitary body according to one of claims 1 to 4,
wherein said piezoelectric substrate (2; 12; 22) is made from lithium niobate.

6. An integrated unitary body according to one of claims 1 to 4,
wherein said piezoelectric substrate (2; 12; 22) is made from lithium tantalate.

7. An integrated unitary body according to one of claims 1 to 4,
wherein said piezoelectric substrate (2; 12; 22) is made from quartz.

8. An integrated unitary body according to one of claims 1 to 7,
wherein said film (8; 18; 28) is made of crystalline silicon.

9. An integrated unitary body according to one of claims 1 to 7,
wherein said film (8; 18; 28) is made of amorphous silicon.

10. An integrated unitary body according to one of claims 1 to 7,
wherein said film (8; 18; 28) is made of silicon oxide.

11. An electro-acoustic hybrid integrated circuit,
comprising:
a semiconductor substrate (1; 11; 21);
a single crystalline piezoelectric substrate (2; 12; 22); and
a film (8; 18; 28) including silicon between said semiconductor substrate (1; 11; 21) and said single crystalline piezoelectric substrate (2; 12; 22);
characterized in that said semiconductor substrate (1; 11; 21) and said piezoelectric substrate (2; 12; 22) are directly bonded via said film (8; 18; 28) without any organic adhesives, wherein the bonding between said film (8; 18; 28) and said semiconductor substrate (1; 11; 21) is between component atoms of said film and oxygen and/or component atoms of said semiconductor substrate (1; 11; 21) and
wherein the bonding between said film (8; 18; 28) and said piezoelectric substrate (2; 12; 22) is between component atoms of said film (8; 18; 28) and oxygen atoms of said piezoelectric substrate (2; 12; 22).

12. The electro-acoustic hybrid integrated circuit according to claim 11,
wherein an active element (3; 13; 23) is formed on the surface of the semiconductor substrate (1; 11; 21).

13. The electro-acoustic hybrid integrated circuit according to claim 12,
wherein an electro-acoustic element comprising said piezoelectric substrate (2; 12; 22) is connected to said active element (3; 13; 23) to form an electro-acoustic circuit.

14. The electro-acoustic hybrid integrated circuit according to claim 13,
wherein said electro-acoustic element is a surface acoustic wave element.

15. The electro-acoustic hybrid integrated circuit according to claim 13,
wherein said electro-acoustic element is a quartz oscillator.

16. The electro-acoustic hybrid integrated circuit according to one of claims 11 to 15,
wherein said active element (3) includes a transistor.

17. The electro-acoustic hybrid integrated circuit according to one of claims 11 to 16,
wherein said semiconductor substrate (1; 11; 21) is made from silicon.

18. The electro-acoustic hybrid integrated circuit according to one of claims 11 to 17,
wherein said semiconductor substrate (1; 11; 21) is made from a III-V compound semiconductor.

19. The electro-acoustic hybrid integrated circuit according to claim 18,
wherein said III-V compound semiconductor is GaAs.

20. The electro-acoustic hybrid integrated circuit according to one of claims 11 to 19,
wherein said piezoelectric substrate (2; 12; 22) is made from lithium niobate.

21. The electro-acoustic hybrid integrated circuit according to one of claims 11 to 19,
wherein said piezoelectric substrate (2; 12; 22) is made from lithium tantalate.

22. The electro-acoustic hybrid integrated circuit according to one of claims 11 to 19,
wherein said piezoelectric substrate (2; 12; 22) is made from quartz.

23. The electro-acoustic hybrid integrated circuit according to one of claims 11 to 22,
wherein said film (8; 18; 28) is made of crystalline silicon.

24. The electro-acoustic hybrid integrated circuit according to one of claims 11 to 22,
wherein said film (8; 18; 28) is made of amorphous silicon.

25. The electro-acoustic hybrid integrated circuit according to one of claims 11 to 22,
wherein said film (8; 18; 28) is made of silicon oxide.

26. The electro-acoustic hybrid integrated circuit according to one of claims 11 to 25,
wherein said electro-acoustic circuit is a voltage controlled oscillator.

27. The electro-acoustic hybrid integrated circuit according to one of claims 11 to 25,
wherein said electro-acoustic circuit is a temperature compensated crystal oscillator.

28. The electro-acoustic hybrid integrated circuit according to one of claims 11 to 25,
wherein said electro-acoustic circuit is a high frequency amplifier.

29. The electro-acoustic hybrid integrated circuit according to one of claims 11 to 28,
wherein a peripheral section of said piezoelectric substrate (2; 12; 22) and said semiconductor substrate (1; 11; 21) are directly bonded via said film (8; 18; 28).

30. A method for manufacturing an unitary body for use in an electronic device, especially for use in an electro-acoustic hybrid integrated circuit, said method comprising the steps of:
providing a semiconductor substrate (1; 11; 21);
providing a single crystalline piezoelectric substrate (2; 12; 22);
forming a film (8; 18; 28) including silicon on at least one of said semiconductor substrate (1; 11; 21) and said piezoelectric substrate (2; 12; 22); and
bonding said semiconductor substrate (1; 11; 21) with said piezoelectric substrate (2; 12; 22) via said film (8; 18; 28);
characterized in that the step of bonding said semiconductor substrate (1; 11; 21) with said piezoelectric substrate (2; 12; 22) comprising the steps of:
cleaning the surface (S5; S45) of said semiconductor substrate (1; 11; 21) or said film (8; 18; 28) formed on said semiconductor substrate (1; 11; 21), respectively, and making it hydrophilic;
cleaning the surface (S13; S53) of said piezoelectric substrate (2; 12; 22) or said film (8; 18; 28) formed on said piezoelectric substrate (2; 12; 22), respectively, making it hydrophilic;
laying it (S21; S61) on the surface of said semiconductor substrate (1; 11; 21) or said film (8; 18; 28) formed on said semiconductor substrate (1; 11; 21), respectively; and
performing heat treatment (S22; S62) of said semiconductor substrate (1; 11; 21) bonded with said piezoelectric substrate (2; 12; 22).

31. The manufacturing method according to claim 30,
wherein said bonding step further comprising the steps of:
washing (S6; S46) the cleaned surface of said semiconductor substrate (1; 11; 21) or said film (8; 18; 28) formed on said semiconductor substrate (1; 11; 21), respectively, with pure water; and
washing (S14; S54) the cleaned surface of said piezoelectric substrate (2; 12; 22) or said film (8; 18; 28) formed on said piezoelectric substrate (2; 12; 22), respectively, with pure water;
said washing steps (S6, S14; S46, S 54) being performed before attachment of the cleaned surfaces.

32. The manufacturing method according to claim 31,
wherein the heat treatment is performed in a temperature range between 100 and 800 °C.

33. The manufacturing method according to claim 31,
wherein the heat treatment is performed in a temperature range between 300 and 600 °C.

34. The manufacturing method according to one of claims 30 to 33,
wherein said semiconductor substrate (1; 11; 21) is made from silicon.

35. The manufacturing method according to one of claims 30 to 33,
wherein said semiconductor substrate (1; 11; 21) is made from a III-V compound semiconductor.

36. The manufacturing method according to claim 35,
wherein said III-V compound semiconductor is GaAs.

37. The manufacturing method according to one of claims 30 to 36,
wherein said piezoelectric substrate (2; 12; 22) is made from lithium niobate.

38. The manufacturing method according to one of claims 30 to 36,
wherein said piezoelectric substrate (2; 12; 22) is made from lithium tantalate.

39. The manufacturing method according to one of claims 30 to 36,
wherein said piezoelectric substrate (2; 12; 22) is made from quartz.

40. The manufacturing method according to one of claims 30 to 39,
wherein said film (8; 18; 28) is made of crystalline silicon.

41. The manufacturing method according to one of claims 30 to 39,
wherein said film (8; 18; 28) is made of amorphous silicon.

42. The manufacturing method according to one of claims 30 to 39,
wherein said film (8; 18; 28) is made of silicon oxide.

43. A manufacturing method for manufacturing an electro-acoustic hybrid integrated circuit, the method comprising the steps of:
providing a unitary body by a manufacturing method according to one of the claims 30 to 42;
performing processes for forming an active element on said semiconductor substrate (1; 11; 21);
performing processes for forming an electro-acoustic element on said piezoelectric substrate (2; 12; 22); and
performing processes for forming a metal pattern to connect said active element and said electro-acoustic element;
whereby an active element and an electro-acoustic element are integrated as one body.

44. The manufacturing method according to claim 43,
wherein the processes necessary for forming said active element are carried out before direct bonding said semiconductor substrate (1; 11; 21) and said piezoelectric substrate (2; 12; 22) at a temperature equal to or higher than the heat treatment temperature for said direct bonding;
wherein the processes after said direct bonding are processed at a temperatures below the heat treatment temperature for said direct bonding.

45. The manufacturing method according to claims 43 or 44,
wherein said active element includes a transistor.

46. The manufacturing method according to one of claims 43 to 45,
wherein passive electronics components to be used to construct said electro-acoustic circuit are manufactured at the same time in the steps of performing processes necessary for forming said active element.

47. The manufacturing method according to one of claims 43 to 46,
wherein said electro-acoustic circuit is a voltage controlled oscillator.

48. The manufacturing method according to one of claims 43 to 46,
wherein said electro-acoustic circuit is a temperature compensated crystal oscillator.

49. The manufacturing method according to one of claims 43 to 46,
wherein said electro-acoustic circuit is a high frequency amplifier.

50. The manufacturing method according to one of claims 43 to 49,
wherein said quartz plate is thinned with etching or polishing after said quartz plate is bonded directly to said semiconductor substrate (1; 11; 21).

51. The manufacturing method according to one of claims 43 to SO,
wherein said piezoelectric element (2; 12; 22) is a surface acoustic wave (SAW) element.

52. The manufacturing method according to one of claims 43 to 50,
wherein said piezoelectric element is a quartz oscillator.

53. The manufacturing method according to one of claims 43 to 52,
wherein said piezoelectric element (2; 12; 22) is thinned with etching or polishing after said piezoelectric substrate is bonded directly to said semiconductor substrate (1; 11; 21).

54. The manufacturing method according to one of claims 43 to 53,
further comprising the step of forming a through-hole in said semiconductor substrate (1; 11; 21) to reach and expose the back surface of said piezoelectric substrate (2; 12; 22).

## Patentansprüche

1. Integrierter, einheitlicher Körper zur Verwendung in einer elektronischen Vorrichtung, insbesondere in einer elektroakustischen, integrierten Hybridschaltung, mit:
einem Halbleitersubstrat (1; 11; 21);
einem einkristallinen, piezoelektrischen Substrat (2; 12; 22); und
einer siliziumhaltigen Schicht (8; 18; 28) zwischen dem Halbleitersubstrat (1; 11; 21) und dem einkristallinen, piezoelektrischen Substrat (2; 12; 22);
dadurch gekennzeichnet, daß das Halbleitersubstrat (1; 11; 21) und das piezoelektrische Substrat (2; 12; 22) über diese Schicht (8; 18; 28) ohne jegliche organische Klebemittel direkt verbunden sind, wobei die Verbindung zwischen der Schicht (8; 18; 28) und dem Halbleitersubstrat (1; 11; 21) zwischen Komponentenatomen der Schicht und Sauerstoff- und/oder Komponentenatomen des Halbleitersubstrates (1; 11; 21) stattfindet, und wobei die Verbindung zwischen der Schicht (8; 18; 28) und dem piezoelektrischen Substrat (2; 12; 22) zwischen Komponentenatomen der Schicht (8; 18; 28) und Sauerstoffatomen des piezoelektrischen Substrates (2; 12; 22) stattfindet.

2. Integrierter, einheitlicher Körper nach Anspruch 1,
wobei das Halbleitersubstrat (1; 11; 21) aus Silizium hergestellt ist.

3. Integrierter, einheitlicher Körper nach Anspruch 1,
wobei das Halbleitersubstrat (1; 11; 21) aus einem III-V-Verbindungshalbleiter hergestellt ist.

4. Integrierter, einheitlicher Körper nach Anspruch 3,
wobei der III-V-Verbindungshalbleiter GaAs ist.

5. Integrierter, einheitlicher Körper nach einem der Ansprüche 1 bis 4,
wobei das piezoelektrische Substrat (2; 12; 22) aus Lithiumniobat hergestellt ist.

6. Integrierter, einheitlicher Körper nach einem der Ansprüche 1 bis 4,
wobei das piezoelektrische Substrat (2; 12; 22) aus Lithiumtantalat hergestellt ist.

7. Integrierter, einheitlicher Körper nach einem der Ansprüche 1 bis 4,
wobei das piezoelektrische Substrat (2; 12; 22) aus Quarz hergestellt ist.

8. Integrierter, einheitlicher Körper nach einem der Ansprüche 1 bis 7,
wobei die Schicht (8; 18; 28) aus kristallinem Silizium hergestellt ist.

9. Integrierter, einheitlicher Körper nach einem der Ansprüche 1 bis 7,
wobei die Schicht (8; 18; 28) aus amorphem Silizium hergestellt ist.

10. Integrierter, einheitlicher Körper nach einem der Ansprüche 1 bis 7, wobei die Schicht (8; 18; 28) aus Siliziumoxid hergestellt.

11. Elektroakustische, integrierte Hybridschaltung, mit:
einem Halbleitersubstrat (1; 11; 21);
einem einkristallinen, piezoelektrischen Substrat (2; 12; 22); und
einer siliziumhaltigen Schicht (8; 18; 28) zwischen dem Halbleitersubstrat (1; 11; 21) und dem einkristallinen, piezoelektrischen Substrat (2; 12; 22);
dadurch gekennzeichnet, daß das Halbleitersubstrat (1; 11; 21) und das piezoelektrische Substrat (2; 12; 22) über diese Schicht (8; 18; 28) ohne jegliche organische Klebemittel direkt verbunden sind, wobei die Verbindung zwischen der Schicht (8; 18; 28) und dem Halbleitersubstrat (1; 11; 21) zwischen Komponentenatomen der Schicht und Sauerstoff- und/oder Komponentenatomen des Halbleitersubstrates (1; 11; 21) stattfindet, und wobei die Verbindung zwischen der Schicht (8; 18; 28) und dem piezoelektrischen Substrat (2; 12; 22) zwischen Komponentenatomen der Schicht (8; 18; 28) und Sauerstoffatomen des piezoelektrischen Substrates (2; 12; 22) stattfindet.

12. Elektroakustische, integrierte Hybridschaltung nach Anspruch 11,
wobei ein aktives Element (3; 13; 23) auf der Oberfläche des Halbleitersubstrates (1; 11; 21) ausgebildet ist.

13. Elektroakustische, integrierte Hybridschaltung nach Anspruch 12,
wobei ein elektroakustisches Element mit einem piezoelektrischen Substrat (2; 12; 22) mit dem aktiven Element (3; 13; 23) verbunden ist, um eine elektroakustische Schaltung zu bilden.

14. Elektroakustische, integrierte Hybridschaltung nach Anspruch 13,
wobei das elektroakustische Element ein Oberflächenwellenelement ist.

15. Elektroakustische, integrierte Hybridschaltung nach Anspruch 13, wobei das elektroakustische Element ein Quarzoszillator ist.

16. Elektroakustische, integrierte Hybridschaltung nach einem der Ansprüche 11 bis 15,
wobei das aktive Element (3) einen Transistor einschließt.

17. Elektroakustische, integrierte Hybridschaltung nach einem der Ansprüche 11 bis 16,
wobei das Halbleitersubstrat (1; 11; 21) aus Silizium hergestellt ist.

18. Elektroakustische, integrierte Hybridschaltung nach einem der Ansprüche 11 bis 17,
wobei das Halbleitersubstrat (1; 11; 21) aus einem III-V-Verbindungshalbleiter hergerstellt ist.

19. Elektroakustische, integrierte Hybridschaltung nach Anspruch 18,
wobei der III-V-Verbindungshalbleiter GaAs ist.

20. Elektroakustische, integrierte Hybridschaltung nach einem der Ansprüche 11 bis 19,
wobei das piezoelektrische Substrat (2; 12; 22) aus Lithiumniobat hergestellt ist.

21. Elektroakustische, integrierte Hybridschaltung nach einem der Ansprüche 11 bis 19,
wobei das piezoelektrische Substrat (2; 12; 22) aus Lithiumtantalat hergestellt ist.

22. Elektroakustische, integrierte Hybridschaltung nach einem der Ansprüche 11 bis 19,
wobei das piezoelektrische Substrat (2; 12; 22) aus Quarz hergestellt ist.

23. Elektroakustische, integrierte Hybridschaltung nach einem der Ansprüche 11 bis 22,
wobei die Schicht (8; 18; 28) aus kristallinem Silizium hergestellt ist.

24. Elektroakustische, integrierte Hybridschaltung nach einem der Ansprüche 11 bis 22,
wobei die Schicht (8; 18; 28) aus amorphem Silizium hergestellt ist.

25. Elektroakustische, integrierte Hybridschaltung nach einem der Ansprüche 11 bis 22,
wobei die Schicht (8; 18; 28) aus Siliziumoxid hergestellt ist.

26. Elektroakustische, integrierte Hybridschaltung nach einem der Ansprüche 11 bis 25,
wobei die elektroakustische Schaltung ein spannungsgesteuerter Oszillator ist.

27. Elektroakustische, integrierte Hybridschaltung nach einem der Ansprüche 11 bis 25,
wobei die elektroakustische Schaltung ein temperaturkompensierter Kristalloszillator ist.

28. Elektroakustische, integrierte Hybridschaltung nach einem der Ansprüche 11 bis 25,
wobei die elektroakustische Schaltung ein Hochfrequenzverstärker ist.

29. Elektroakustische, integrierte Hybridschaltung nach einem der Ansprüche 11 bis 28,
wobei ein peripherer Abschnitt des piezoelektrischen Substrates (2; 12; 22) und des Halbleitersubstrates (1; 11; 21) direkt über die Schicht (8; 18; 28) verbunden sind.

30. Verfahren zur Herstellung eines einheitlichen Körpers zur Verwendung in einer elektronischen Vorrichtung, insbesondere zur Verwendung in einer elektroakustischen, integrierten Hybridschaltung, wobei das Verfahren die Schritte einschließt:
ein Halbleitersubstrat (1; 11; 21) wird zur Verfügung gestellt;
ein einkristallines piezoelektrisches Substrat (2; 12; 22) wird zur Verfügung gestellt;
eine Schicht (8; 18; 28) mit Silizium wird auf mindestens dem Halbleitersubstrat (1; 11; 21) und/oder mindestens dem piezoelektrischen Substrat (2; 12; 22) gebildet; und
das Halbleitersubstrat (1; 11; 21) wird über die Schicht (8; 18; 28) mit dem piezoelektrischen Substrat (2; 12; 22) verbunden;
gekennzeichnet durch den Schritt des Verbindens des Halbleitersubstrates (1; 11; 21) mit dem piezoelektrischen Substrat (2; 12; 22), welcher die Schritte enthält: die Oberfläche (S5; S45) des Halbleitersubstrates (1; 11; 21) oder der auf dem Halbleitersubstrat (1; 11; 21) gebildeten Schicht (8; 18; 28) wird gereinigt, und sie wird hydrophil gemacht;
die Oberfläche (S13, S53) des piezoelektrischen Substrates (2; 12; 22) oder der auf dem piezoelektrischen Substrat (2; 12; 22) gebildeten Schicht (8; 18; 28) wird gereinigt, und sie wird hydrophil gemacht;
sie (S21; S61) wird auf die Oberfläche des Halbleitersubstrates (1; 11; 21) oder auf die auf dem Halbleitersubstrat (1; 11; 21) gebildete Schicht (8; 18; 28) gelegt; und
eine Hitzebehandlung (S22; S62) des mit dem piezoelektrischen Substrat (2; 12; 22) verbundenen Halbleitersubstrates (1; 11; 21) wird ausgeführt.

31. Herstellungsverfahren nach Anspruch 30,
wobei der Schritt des Verbindens weiterhin die Schritte enthält:
die gereinigte Oberfläche des Halbleitersubstrates (1; 11; 21) oder der auf dem Halbleitersubstrat (1; 11; 21) gebildeten Schicht (8; 18; 28) wird mit reinem Wasser gespült; und
die gereinigte Oberfläche des piezoelektrischen Substrates (2; 12; 22) oder der auf dem piezoelektrischen Substrat (2; 12; 22) gebildeten Schicht (8; 18; 28) wird mit reinem Wasser gespült (S14; S54);
wobei die Spülschritte (S6, S14; S46, S54) vor dem Anbringen der gereinigten Oberflächen ausgeführt werden.

32. Herstellungsverfahren nach Anspruch 31,
wobei die Hitzebehandlung in einem Temperaturbereich zwischen 100 und 800°C ausgeführt wird.

33. Herstellungsverfahren nach Anspruch 31,
wobei die Hitzebehandlung in einem Temperaturbereich zwischen 300 und 600°C ausgeführt wird.

34. Herstellungsverfahren nach einem der Ansprüche 30 bis 33,
wobei das Halbleitersubstrat (1; 11; 21) aus Silizium hergestellt ist.

35. Herstellungsverfahren nach einem der Ansprüche 30 bis 33,
wobei das Halbleitersubstrat (1; 11; 21) aus einem III-V-Verbindungshalbleiter hergestellt ist.

36. Herstellungsverfahren nach Anspruch 35,
wobei der III-V-Verbindungshalbleiter GaAs ist.

37. Herstellungsverfahren nach einem der Ansprüche 30 bis 36,
wobei das piezoelektrische Substrat (2; 12; 22) aus Lithiumniobat hergestellt ist.

38. Herstellungsverfahren nach einem der Ansprüche 30 bis 36,
wobei das piezoelektrische Substrat (2; 12; 22) aus Lithiumtantalat hergestellt ist.

39. Herstellungsverfahren nach einem der Ansprüche 30 bis 36,
wobei das piezoelektrische Substrat (2; 12; 22) aus Quarz hergestellt ist.

40. Herstellungsverfahren nach einem der Ansprüche 30 bis 39,
wobei die Schicht (8; 18; 28) aus kristallinem Silizium hergestellt ist.

41. Herstellungsverfahren nach einem der Ansprüche 30 bis 39,
wobei die Schicht (8; 18; 28) aus amorphem Silizium hergestellt ist.

42. Herstellungsverfahren nach einem der Ansprüche 30 bis 39,
wobei die Schicht (8; 18; 28) aus Siliziumoxid hergestellt ist.

43. Herstellungsverfahren zum Herstellen einer elektroakustischen, integrierten Hybridschaltung, wobei das Verfahren die Schritte einschließt:
ein einheitlicher Körper wird durch ein Herstellungsverfahren gemäß einem der Ansprüche 30 bis 42 zur Verfügung gestellt;
es werden Prozesse zum Bilden eines aktiven Elementes auf dem Halbleitersubstrat (1; 11; 21) ausgeführt;
es werden Prozesse zum Bilden eines elektroakustischen Elementes auf dem piezoelektrischen Substrat (2; 12; 22) ausgeführt; und
es werden Prozesse zum Bilden eines Metallmusters ausgeführt, um das aktive Element und das elektroakustische Element zu verbinden;
wobei ein aktives Element und ein elektroakustisches Element als ein Körper integriert werden.

44. Herstellungsverfahren nach Anspruch 43,
wobei die zum Bilden des aktiven Elementes notwendigen Prozesse ausgeführt
werden, bevor das Halbleitersubstrat (1; 11; 21) und das piezoelektrische Substrat (2; 12; 22) direkt bei einer Temperatur verbunden werden, die gleich oder höher ist als die Wärmebehandlungstemperatur für das direkte Verbinden;
wobei die Prozesse nach dem direkten Verbinden bei einer Temperatur unterhalb der Wärmebehandlungstemperatur für das direkte Verbinden ausgeführt werden.

45. Herstellungsverfahren nach den Ansprüchen 43 oder 44,
wobei das aktive Element einen Transistor einschließt.

46. Herstellungsverfahren nach einem der Ansprüche 43 bis 45,
wobei zum Bilden der elektroakustischen Schaltung zu verwendende, passive, elektronische Komponenten zur gleichen Zeit bei den Schritten des Ausführens der für die Bildung des aktiven Elementes notwendigen Prozesse hergestellt werden.

47. Herstellungsverfahren nach einem der Ansprüche 43 bis 46,
wobei die elektroakustische Schaltung ein spannungsgesteuerter Oszillator ist.

48. Herstellungsverfahren nach einem der Ansprüche 43 bis 46,
wobei die elektroakustische Schaltung ein temperaturkompensierter Kristalloszillator ist.

49. Herstellungsverfahren nach einem der Ansprüche 43 bis 46,
wobei die elektroakustische Schaltung ein Hochfrequenzverstärker ist.

50. Herstellungsverfahren nach einem der Ansprüche 43 bis 49,
wobei die Quarzplatte durch Ätzen oder Polieren verdünnt wird, nachdem die Quarzplatte direkt mit dem Halbleitersubstrat (1; 11; 21) verbunden wird.

51. Herstellungsverfahren nach einem der Ansprüche 43 bis 50,
wobei das piezoelektrische Element (2; 12; 22) ein Oberflächenwellen (SAW)-Element ist.

52. Herstellungsverfahren nach einem der Ansprüche 43 bis 50,
wobei das piezoelektrische Element (2; 12; 22) ein Quarzoszillator ist.

53. Herstellungsverfahren nach einem der Ansprüche 43 bis 52,
wobei das piezoelektrische Element (2; 12; 22) durch Ätzen oder Polieren verdünnt wird, nachdem das piezoelektrische Substrat direkt mit dem Halbleitersubstrat (1; 11; 21) verbunden wird.

54. Herstellungsverfahren nach einem der Ansprüche 43 bis 53,
weiterhin den Schritt des Bildens eines Durchgangsloches in dem Halbleitersubstrat (1; 11; 21) enthaltend, um die rückseitige Oberfläche des piezoelektrischen Substrates (2; 12; 22) zu erreichen und zu exponieren.

## Revendications

1. Corps unitaire intégré destiné à être utilisé dans un dispositif électronique, en particulier dans un circuit électroacoustique hybride intégré,
comprenant :
un substrat de semiconducteur (1 ; 11 ; 21),
un substrat piézo-électrique monocristallin (2 ; 12 ; 22), et
une couche (8 ; 18 ; 28) comprenant du silicium entre ledit substrat de semiconducteur (1 ; 11 ; 21) et ledit substrat piézo-électrique monocristallin (2 ; 12 ; 22),
caractérisé en ce que ledit substrat de semiconducteur (1 ; 11 ; 21) et ledit substrat piézo-électrique (2 ; 12 ; 22) sont liés directement par l'intermédiaire de ladite couche (8 ; 18 ; 28) sans aucun adhésif organique, dans lequel la liaison entre ladite couche (8 ; 18 ; 28) et ledit substrat de semiconducteur (1 ; 11 ; 21) se fait entre des atomes constitutifs de ladite couche et des atomes d'oxygène et/ou constitutifs dudit substrat de semiconducteur (1 ; 11 ; 21), et dans lequel la liaison entre ladite couche (8 ; 18 ; 28) et ledit substrat piézo-électrique (2 ; 12 ; 22) se fait entre des atomes constitutifs de ladite couche (8 ; 18 ; 28) et des atomes d'oxygène dudit substrat piézo-électrique (2 ; 12 ; 22).

2. Corps unitaire intégré selon la revendication 1,
dans lequel ledit substrat de semiconducteur (1 ; 11 ; 21) est fait de silicium.

3. Corps unitaire intégré selon la revendication 1,
dans lequel ledit substrat de semiconducteur (1 ; 11 ; 21) est fait d'un semiconducteur composé des groupes III-V.

4. Corps unitaire intégré selon la revendication 3,
dans lequel ledit semiconducteur composé des groupes III-V est du GaAs.

5. Corps unitaire intégré selon l'une des revendications 1 à 4,
dans lequel ledit substrat piézo-électrique (2 ; 12 ; 22) est fait de niobate de lithium.

6. Corps unitaire intégré selon l'une des revendications 1 à 4,
dans lequel ledit substrat piézo-électrique (2 ; 12 ; 22) est fait de tantalate de lithium.

7. Corps unitaire intégré selon l'une des revendications 1 à 4,
dans lequel ledit substrat piézo-électrique (2 ; 12 ; 22) est fait de quartz.

8. Corps unitaire intégré selon l'une des revendications 1 à 7,
dans lequel ladite couche (8 ; 18 ; 28) est faite de silicium cristallin.

9. Corps unitaire intégré selon l'une des revendications 1 à 7,
dans lequel ladite couche (8 ; 18 ; 28) est faite de silicium amorphe.

10. Corps unitaire intégré selon l'une des revendications 1 à 7,
dans lequel ladite couche (8 ; 18 ; 28) est faite d'oxyde de silicium.

11. Circuit électroacoustique hybride intégré
comprenant :
un substrat de semiconducteur (1 ; 11 ; 21),
un substrat piézo-électrique monocristallin (2 ; 12 ; 22), et
une couche (8 ; 18 ; 28) comprenant du silicium entre ledit substrat de semiconducteur (1 ; 11 ; 21) et ledit substrat piézo-électrique monocristallin (2 ; 12 ; 22),
caractérisé en ce que ledit substrat de semiconducteur (1 ; 11 ; 21) et ledit substrat piézo-électrique (2 ; 12 ; 22) sont liés directement par l'intermédiaire de ladite couche (8 ; 18 ; 28) sans aucun adhésif organique, dans lequel la liaison entre ladite couche (8 ; 18 ; 28) et ledit substrat de semiconducteur (1 ; 11 ; 21) se fait entre des atomes constitutifs de ladite couche et des atomes d'oxygène et/ou constitutifs dudit substrat de semiconducteur (1 ; 11 ; 21), et
dans lequel la liaison entre ladite couche (8 ; 18 ; 28) et ledit substrat piézo-électrique (2 ; 12 ; 22) se fait entre des atomes constitutifs de ladite couche (8 ; 18 ; 28) et des atomes d'oxygène dudit substrat piézo-électrique (2 ; 12 ; 22).

12. Circuit électroacoustique hybride intégré selon la revendication 11,
dans lequel un élément actif (3 ; 13 ; 23) est formé sur la surface du substrat de semiconducteur (1 ; 11 ; 21).

13. Circuit électroacoustique hybride intégré selon la revendication 12,
dans lequel un élément électroacoustique comprenant ledit substrat piézo-électrique (2 ; 12 ; 22) est relié audit élément actif (3 ; 13 ; 23) afin de former un circuit électroacoustique.

14. Circuit électroacoustique hybride intégré selon la revendication 13,
dans lequel ledit élément électroacoustique est un élément à onde acoustique de surface.

15. Circuit électroacoustique hybride intégré selon la revendication 13,
dans lequel ledit élément électroacoustique est un oscillateur à quartz.

16. Circuit électroacoustique hybride intégré selon l'une des revendications 11 à 15,
dans lequel ledit élément actif (3) comprend un transistor.

17. Circuit électroacoustique hybride intégré selon l'une des revendications 11 à 16,
dans lequel ledit substrat de semiconducteur (1 ; 11 ; 21) est fait de silicium.

18. Circuit électroacoustique hybride intégré selon l'une des revendications 11 à 17,
dans lequel ledit substrat de semiconducteur (1 ; 11 ; 21) est fait d'un semiconducteur composé des groupes III-V.

19. Circuit électroacoustique hybride intégré selon la revendication 18, dans lequel ledit semiconducteur composé des groupes III-V est du GaAs.

20. Circuit électroacoustique hybride intégré selon l'une des revendications 11 à 19,
dans lequel ledit substrat piézo-électrique (2 ; 12 ; 22) est fait de niobate de lithium.

21. Circuit électroacoustique hybride intégré selon l'une des revendications il à 19, dans lequel ledit substrat piézo-électrique (2 ; 12 ; 22) est fait de tantalate de lithium.

22. Circuit électroacoustique hybride intégré selon l'une des revendications 11 à 19,
dans lequel ledit substrat piézo-électrique (2 ; 12 ; 22) est fait de quartz.

23. Circuit électroacoustique hybride intégré selon l'une des revendications 11 à 22, dans lequel ladite couche (8 ; 18 ; 28) est faite de silicium cristallin.

24. Circuit électroacoustique hybride intégré selon l'une des revendications 11 à 22,
dans lequel ladite couche (8 ; 18 ; 28) est faite de silicium amorphe.

25. Circuit électroacoustique hybride intégré selon l'une des revendications 11 à 22,
dans lequel ladite couche (8 ; 18 ; 28) est faite d'oxyde de silicium.

26. Circuit électroacoustique hybride intégré selon l'une des revendications 11 à 25,
dans lequel ledit circuit électroacoustique est un oscillateur commandé en tension.

27. Circuit électroacoustique hybride intégré selon l'une des revendications 11 à 25,
dans lequel ledit circuit électroacoustique est un oscillateur à quartz compensé en température.

28. Circuit électroacoustique hybride intégré selon l'une des revendications 11 à 25,
dans lequel ledit circuit électroacoustique est un amplificateur haute fréquence.

29. Circuit électroacoustique hybride intégré selon l'une des revendications 11 à 28,
dans lequel une partie périphérique dudit substrat piézo-électrique (2 ; 12 ; 22) et ledit substrat de semiconducteur (1 ; 11 ; 21) sont liés directement par l'intermédiaire de ladite couche (8 ; 18 ; 28).

30. Procédé de fabrication d'un corps unitaire destiné à être utilisé dans un dispositif électronique, en particulier destiné à être utilisé dans un circuit électroacoustique hybride intégré, ledit procédé comprenant les étapes consistant à :
prévoir un substrat de semiconducteur (1 ; 11 ; 21),
prévoir un substrat piézo-électrique monocristallin (2 ; 12 ; 22),
former une couche (8 ; 18 ; 28) comprenant du silicium sur au moins l'un dudit substrat de semiconducteur (1 ; 11 ; 21) et dudit substrat piézo-électrique (2 ; 12 ; 22), et
lier ledit substrat de semiconducteur (1 ; 11 ; 21) audit substrat piézo-électrique (2 ; 12 ; 22) par l'intermédiaire de ladite couche (8 ; 18 ; 28),
caractérisé en ce que l'étape de liaison dudit substrat de semiconducteur (1 ; 11 ; 21) audit substrat piézo-électrique (2 ; 12 ; 22) comprend les étapes consistant à :
nettoyer la surface (S5 ; S45) dudit substrat de semiconducteur (1 ; 11 ; 21) ou de ladite couche (8 ; 18 ; 28) formée sur ledit substrat de semiconducteur (1 ; 11 ; 21), respectivement, et la rendre hydrophile,
nettoyer la surface (S13 ; S53) dudit substrat piézo-électrique (2 ; ; 12 ; 22) ou de ladite couche (8 ; 18 ; 28) formée sur ledit substrat piézo-électrique (2 ; 12 ; 22), respectivement, en la rendant hydrophile,
l'appliquer (S21 ; S61) sur la surface dudit substrat de semiconducteur (1 ; 11 ; 21) ou de ladite couche (8 ; 18 ; 28) formée sur ledit substrat de semiconducteur (1 ; 11 ; 21), respectivement, et
effectuer un traitement thermique (S22 ; S62) dudit substrat de semiconducteur (1 ; 11 ; 21) lié audit substrat piézo-électrique (2 ; 12 ; 22).

31. Procédé de fabrication selon la revendication 30,
dans lequel ladite étape de liaison comprend en outre les étapes consistant à :
laver (S6 ; S46) la surface nettoyée dudit substrat de semiconducteur (1 ; 11 ; 21) ou de ladite couche (8 ; 18 ; 28) formée sur ledit substrat de semiconducteur (1 ; 11 ; 21), respectivement, avec de l'eau pure, et
laver (S14 ; S54) la surface nettoyée dudit substrat piézo-électrique (2 ; 12 ; 22) ou de ladite couche (8 ; 18 ; 28) formée sur ledit substrat piézo-électrique (2 ; 12 ; 22), respectivement, avec de l'eau pure,
lesdites étapes de lavage (S6, S14 ; S46, S54) étant effectuées avant la fixation des surfaces nettoyées.

32. Procédé de fabrication selon la revendication 31,
dans lequel le traitement thermique est effectué dans une plage de températures comprises entre 100 et 800° C.

33. Procédé de fabrication selon la revendication 31,
dans lequel le traitement thermique est effectué dans une plage de températures comprises entre 300 et 600° C.

34. Procédé de fabrication selon l'une des revendications 30 à 33,
dans lequel ledit substrat de semiconducteur (1 ; 11 ; 21) est fait de silicium.

35. Procédé de fabrication selon l'une des revendications 30 à 33,
dans lequel ledit substrat de semiconducteur (1 ; 11 ; 21) est fait d'un semiconducteur composé des groupes III-V.

36. Procédé de fabrication selon la revendication 35,
dans lequel ledit semiconducteur composé des groupes III-V est du GaAs.

37. Procédé de fabrication selon l'une des revendications 30 à 36,
dans lequel ledit substrat piézo-électrique (2 ; ; 12 ; 22) est fait de niobate de lithium.

38. Procédé de fabrication selon l'une des revendications 30 à 36,
dans lequel ledit substrat piézo-électrique (2 ; 12 ; 22) est fait de tantalate de lithium.

39. Procédé de fabrication selon l'une des revendications 30 à 36,
dans lequel ledit substrat piézo-électrique (2 ; 12 ; 22) est fait de quartz.

40. Procédé de fabrication selon l'une des revendications 30 à 39,
dans lequel ladite couche (8 ; 18 ; 28) est faite de silicium cristallin.

41. Procédé de fabrication selon l'une des revendications 30 à 39,
dans lequel ladite couche (8 ; 18 ; 28) est faite de silicium amorphe.

42. Procédé de fabrication selon l'une des revendications 30 à 39,
dans lequel ladite couche (8 ; 18 ; 28) est faite d'oxyde de silicium.

43. Procédé de fabrication destiné à la fabrication d'un circuit électroacoustique hybride intégré, le procédé comprenant les étapes consistant à :
former un corps unitaire grâce au procédé de fabrication selon l'une des revendications 30 à 42,
effectuer des traitements afin de former un élément actif sur ledit substrat de semiconducteur (1 ; 11 ; 21),
effectuer les traitements afin de former un élément électroacoustique sur ledit substrat piézo-électrique (2 ; 12 ; 22), et
effectuer des traitements afin de former un motif métallique destiné à relier ledit élément actif et ledit élément électroacoustique,
grâce à quoi un élément actif et un élément électroacoustique sont intégrés sous forme d'un seul corps.

44. Procédé de fabrication selon la revendication 23,
dans lequel les traitements nécessaires à la formation dudit élément actif sont exécutés avant la liaison directe dudit substrat de semiconducteur (1 ; 11 ; 21) et dudit substrat piézo-électrique (2 ; 12 ; 22) à une température égale ou supérieure à la température de traitement thermique destinée à ladite liaison directe,
dans lequel les traitements après ladite liaison directe sont effectués à une température inférieure à la température de traitement thermique destinée à ladite liaison directe.

45. Procédé de fabrication selon les revendications 43 ou 44,
dans lequel ledit élément actif comprend un transistor.

46. Procédé de fabrication selon l'une des revendications 43 à 45,
dans lequel des composants électroniques passifs devant être utilisés pour construire ledit circuit électroacoustique sont fabriqués simultanément aux étapes consistant à effectuer des traitements nécessaires à la formation dudit élément actif.

47. Procédé de fabrication selon l'une des revendications 43 à 46,
dans lequel ledit circuit électroacoustique est un oscillateur commandé en tension.

48. Procédé de fabrication selon l'une des revendications 43 à 46,
dans lequel ledit circuit électroacoustique est un oscillateur à quartz compensé en température.

49. Procédé de fabrication selon l'une des revendications 43 à 46,
dans lequel ledit circuit électroacoustique est un amplificateur haute fréquence.

50. Procédé de fabrication selon l'une des revendications 43 à 49,
dans lequel ladite lame de quartz est amincie après que ladite lame de quartz soit liée directement audit substrat de semiconducteur (1 ; 11 ; 21).

51. Procédé de fabrication selon l'une des revendications 43 à 50,
dans lequel ledit élément piézo-électrique (2 ; 12 ; 22) est un élément à onde acoustique de surface (SAW).

52. Procédé de fabrication selon l'une des revendications 43 à 50,
dans lequel ledit élément piézo-électrique est un oscillateur à quartz.

53. Procédé de fabrication selon l'une des revendications 43 à 52,
dans lequel ledit élément piézo-électrique (2 ; 12 ; 22) est aminci par gravure ou polissage après que ledit substrat piézo-électrique ait été lié directement audit substrat de semiconducteur (1 ; 11 ; 21).

54. Procédé de fabrication selon l'une des revendications 43 à 53, comprenant en outre l'étape consistant à former un trou traversant dans ledit substrat de semiconducteur (1 ; 11 ; 21) afin d'atteindre et d'exposer la surface de dos dudit substrat piézo-électrique (2 ; 12 ; 22).
